# EUROPEAN PATENT SPECIFICATION

(11) **EP 2 050 577 B1**
(45) Date of publication and mention of the grant of the patent: **06.05.2015**
(21) Application number: 07792241.7
(22) Date of filing: 09.08.2007
(51) Int. Cl.: B41N 3/00, B05C 9/12, B05C 11/04, B05D 3/12, B41N 1/12, B41N 1/22, B41N 6/00, G03F 7/00

(54) **PRODUCTION METHOD AND PRODUCTION DEVICE OF CYLINDRICAL PRINT SUBSTRATE**
HERSTELLUNGSVERFAHREN UND HERSTELLUNGSVORRICHTUNG FÜR ZYLINDRISCHEN DRUCKTRÄGER
PROCÉDÉ DE PRODUCTION ET DISPOSITIF DE PRODUCTION DE SUBSTRAT D'IMPRESSION CYLINDRIQUE

(30) Priority: 09.08.2006 JP 2006217271
(43) Date of publication of application: 22.04.2009
(73) Proprietor: Asahi Kasei Chemicals Corporation, Tokyo 101-8101 (JP)
(72) Inventor: WATANABE, Miyoshi, Tokyo 100-8440 (JP)
(74) Representative: Strehl Schübel-Hopf & Partner
(86) International application number: PCT/JP2007/065589
(87) International publication number: WO 2008/018530

(56) References cited:
- WO-A1-2005/005147
- JP-A- 04 110 066
- JP-A- 08 173 893
- JP-A- 52 062 503
- JP-A- 2003 039 848
- JP-A- 2004 255 811
- JP-A- 2004 255 812
- JP-U- 62 059 164
- US-A- 3 637 419

## Description

### Technical Field

The present invention relates to a method of manufacturing a cylindrical printing substrate and a manufacturing device and, more particularly to a method of manufacturing a printing substrate and a manufacturing device suitably used for formation of a relief image for flexographic printing plate, formation of a relief image for dry offset printing such as can printing, formation of a pattern for surface treatment such as embossing, and formation of a relief image for printing for a tile and the like.

### Background Art

The flexographic printing used for printing on packing materials such as a cardboard, a paper package, a paper bag, a film for soft packaging and the like, interior materials in construction such as a wall paper, a decorative plate, a labels, and the like, has particularly increasing its share in various printing methods in recent years.

For a printing plate used for this flexographic printing, a photosensitive resin is generally used, and there is a liquid resin or a solid resin plate formed in a sheet state. By using a plate making device exclusively for the liquid or solid plate, a photosensitive resin letterpress printing plate on which a relief image is formed through a negative film is obtained, which is directly affixed on a plate cylinder of a printing machine or affixed on a carrier sheet or a sleeve for printing once and then, the carrier sheet or the sleeve for printing is attached on the plate cylinder for printing.

Also, with a purpose of improvement of printing quality, a sheet having cushioning properties is inserted between a printing plate and a plate cylinder of a printing machine. Alternatively, a printing plate with cushion in which the printing plate and the cushion sheet are integrated, or a sleeve plate obtained by affixing a double-sided adhesive cushion tape on a sleeve for printing and affixing a solid resin plate thereon has been generally used conventionally.
As a material of such a cushion, a thermosetting urethane foam or a polyethylene foam is used.

For the photosensitive resin solid plate, in response to development of the recent digital image technology, instead of using a negative film, a structural body (referred to as a flexographic CTP plate) obtained by providing a thin infrared photosensitive layer (black layer) ablative by an infrared laser on the photosensitive resin surface, forming a mask image by laser drawing and then, exposing it through the mask (See Patent Document 1, for example) and an outer-face drum type drawing device in which an infrared photosensitive layer of the flexographic CTP plate is selectively ablated by the infrared laser on the basis of digital image information so as to form a mask (See Patent Document 2, for example) are proposed.

Regarding the flexographic CTP plate, relief exposure is carried out through the above-mentioned infrared photosensitive layer mask, and the exposed photosensitive resin is light-cured. After that, by washing off unexposed resin with perchloroethylene (1, 1, 1-trichloroethylene), which is a chlorinated solvent, alone or combination with alcohol such as n-butanol; or hydrocarbon solvent developer such as "Sorbit" (trademark, manufactured by MacDermid), which is a non-chlorinated alternative solvent, a relief image is formed and a flexographic printing plate is obtained through a drying step and a finishing step (photochemical treatment, chemical treatment, and the like).

In contrast to such a plane plate making, regarding a cylindrical plate making (sleeve plate making), too, numerous manufacturing methods and devices in which a photosensitive polymer (liquid or sheet-like solid resin plate) has been widely used in the letterpress printing field and advantageous in terms of a manufacturing method is applied are proposed.

As a method of providing a printing plate on a sleeve, a method of manufacturing a plate material on which a continuous printing pattern without a seam (seamless) can be printed by using a liquid photosensitive resin diluted by a solvent is known (See Patent Document 3, for example). In this Patent Document 3, such a manufacturing method is proposed in which an endless-state material is rotated, and the liquid photosensitive resin is supplied to the rotating surface and smoothed by a doctor.

Also, in Patent Document 4, a method in which the liquid photosensitive resin diluted by a solvent is applied by spraying, soaking, application roller, curtain coater or a nozzle push-out method so as to dry and evaporate the solvent is proposed.

Moreover, numerous manufacturing methods and devices for letterpress for seamless printing to which the photosensitive resin solid plate, instead of the liquid photosensitive resin, is applied are proposed. For example, in Patent Document 5, a manufacturing method in which plural pieces of thermoplastic photosensitive films are overlapped and wound around a cylinder and the integrated photosensitive film obtained by pressurization/heating is made into an exact dimension and then, forming processing is applied by mechanical compression, grinding or polishing for calendar finishing is proposed.

Furthermore, in Patent Document 6, a manufacturing method and a device for manufacturing a seamless sleeve by heating a thermal plastic photosensitive resin into a molten state on an outer circumferential surface of a sleeve supported by a mandrel, and rolling and glazing by a calendar roll method are proposed.

Furthermore, a method of manufacturing a plate material capable of printing a continuous printing pattern without a seam (seamless) by using a liquid photosensitive resin is proposed (See Patent Document 7 and Patent Document 8, for example).

In Patent Document 7, a method and a device for manufacturing an original plate for a seamless printing through an application step in which a liquid photosensitive resin is supplied to a cylinder outer circumferential surface while the cylinder is rotated, and an exposure step in which an active beam is irradiated to the applied liquid resin layer so as to form a resin cured layer are proposed.

In Patent Document 8, while a printing sleeve integrally supported by a printing cylinder or a metal mandrel is rotated, a photosensitive resin liquid is supplied, in a linear mode with a desired application width by resin supply means, to a resin-receiving plate with inclination with a distal end in a doctor-blade shape; the supplied photosensitive resin liquid is fluidized by using an inclination angle of the plate; and a thickness is regulated when the photosensitive resin liquid passes through a distal-end edge of the plate. In this document, a method and a device for manufacturing an original plate for seamless printing through a step of applying a photosensitive resin liquid on an outer circumferential surface of the printing cylinder or a printing sleeve and an exposure step for forming a resin cured layer by irradiating an active beam to the applied liquid resin layer are provided.

In Patent Document 9, an application head is linearly moved in the longitudinal direction of a cylinder shaft center; a constant amount of the liquid photosensitive resin is supplied to the outer circumferential surface of the rotating cylinder; and the application thickness of the applied liquid photosensitive resin is made to uniform by the doctor blade, while an active ray is irradiated to the application layer on the opposite side, so as to form a resin cured layer. After that, in a post-treatment step, the active ray is shut off, the doctor blade is separated from the application layer, and the uncured photosensitive resin remaining on the surface of the light-cured resin cured layer is removed so that a seamless printing original plate is manufactured, and such a manufacturing method and a manufacturing device are proposed.

In addition, in Patent Documents 10 and 11, the examples of a method of applying a liquid photosensitive cushion resin containing a thermally expanding microcapsule on an outer circumferential surface of cylindrical support body may include a spray-coating method, a blade-coating method, a gravure-coating method, a reverse-roller coating method, a kiss-touch coating method, a high-pressure air-knife coating method and the like.
Patent Document 1: Japanese Patent Laid-Open No. 11-153865
Patent Document 2: Japanese Patent Laid-Open No. 8-300600
Patent Document 3: Japanese Patent Laid-Open No. 52-62503
Patent Document 4: Japanese Patent Laid-Open No. 52-32704
Patent Document 5: Japanese Patent Laid-Open No. 63-202751
Patent Document 6: Japanese Patent No. 3209928
Patent Document 7: Japanese Patent Laid-Open No. 2002-079645
Patent Document 8: International Publication No. 2005/005147
Patent Document 9: Japanese Patent Laid-Open No. 2003-241397
Patent Document 10: Japanese Patent Laid-Open No. 2004-255811
Patent Document 11: Japanese Patent Laid-Open No. 2004-255812

### Disclosure of the Invention

### Problems to be Solved by the Invention

However, the above-mentioned conventional manufacturing method and device for manufacturing a sleeve printing original plate have the following problems.

In order to obtain a flexographic printing plate without a seam from a photosensitive resin solid plate, in general, as the above Patent Documents 5 and 6, the photosensitive resin solid plate is wrapped around a cylinder surface, an abutted joined spot at end edges is pressurized/heated by a calendar roll and the like to be fusion-bonded and then, grinding and polishing steps are carried out for making the plate thickness uniform and smoothing the surface. However, the work to wrap the photosensitive resin solid plate around the cylinder surface should be carried out such that, first, a double-sided adhesive tape or double-sided adhesive cushion tape is affixed to a circumferential surface of a cylinder outer and then, the photosensitive resin solid plate should be affixed to the tape adhesive layer cleanly in a state with a slight tension so that a defect such as a wrinkle or air accumulation and the like does not occur. Therefore, the work is extremely cumbersome and requires attention, and there is a case where a work error causes defective printing due to plate floating at printing. Also, since pressurization/heating is conducted, bulky equipment and mechanical machining such as grinding and polishing steps and the like are required. Moreover, as an alternative to a negative film, for example, by forming a uniform carbon black layer without a pin hole on a surface layer portion as in the above Patent Document 1, by fabricating a mask through selective ablation and removal of the carbon black layer by a digitally controlled laser drawing device as in the above Patent Document 2, and by going through known steps of exposure, solvent development, drying, post-exposure and the like, a seamless flexographic printing plate can be obtained. However, the complicated steps such as exposure, solvent development, drying, post-exposure and the like are needed, productivity is poor and the system is not favorable in view of environment due to the use of the solvent.

In both of the above Patent Documents 3 and 4, the photosensitive resin is diluted by a solvent before application, and the photosensitive resin layer is cured by having the solvent evaporated after the application. Problems of odor and pollution, a problem of reproducibility due to expansion of an image by defective contact between a negative film and the photosensitive resin layer since the negative film is exposed simply by pressure contact without using vacuum suctioning, or problems of liquid resin forming such as inclusion of air bubbles, which is unavoidable in the liquid resin, total accuracy as a sleeve printing plate not contained in a practical range and the like prevent practical application.

In the above Patent Document 7, when the resin supply mechanism (bucket) is closed so as to stop supply of the liquid photosensitive resin to the cylinder, due to tackiness of the liquid resin at a moment when a bucket blade tip and the resin applied on the cylinder outer circumferential surface are separated from each other, the liquid resin held at the bucket blade tip portion is transferred to a part of the liquid resin layer whose application thickness has been already made uniform, which causes defects of uneven application thickness or a projecting portion and loss of smoothness, and which leads to the accuracy of the printing plate outside the printing application range and defective printing. Also, the air bubbles are mixed into the photosensitive resin liquid contained inside the bucket at opening/closing of the bucket or the smoothing step by the bucket blade tip, and if the photosensitive resin liquid with the air bubbles mixed is applied on the outer circumferential surface of the sleeve, problems in practical use occur such that a deficit portion is caused in the vicinity of the resin layer surface and the printing quality is poor due to absence of a cushion layer and the like.

In the above Patent Document 8, since the photosensitive resin liquid supplied onto the resin receiving plate is applied on the printing sleeve, unless a sufficient amount of the photosensitive resin liquid is supplied in a predetermined application width on the plate till the end of the application, defects such as uneven application thickness or air bubbles in the applied photosensitive resin layer occur. It has been found out by experiments of the present inventor that the resin supply amount of approximately 1.5 times of a resin amount applied to the printing sleeve is required. An extra photosensitive resin not used for application is wasted and raises a manufacturing cost. Also, at a moment when the plate distal-end edge and the resin applied on the sleeve outer circumferential surface are separated from each other, due to the tackiness of the liquid resin, the liquid resin held on the plate side is transferred to a part of the liquid resin layer whose application thickness has been already made uniform, which causes defects of the uneven application thickness or projecting portion and loss of smoothness, and which leads to the accuracy of the printing plate out of the printing application range and defective printing. Also, since the air bubbles generated in the application step are mixed into the photosensitive resin liquid held on the plate, the application thickness per rotation of the printing sleeve has to be controlled to a distance (approximately 0.1 mm) such that the air bubble does not pass through a gap between the plate distal-end edge and the photosensitive resin surface layer applied on the sleeve outer circumferential surface. Also, there are some problems in practical use such that if the application thickness is increased, the application step takes a long time, which leads to low productivity, poor printing quality due to absence of the cushion layer and the like.

In the above Patent Document 9, since the exposure step is carried out on the opposite side at the same time as the smoothing step by the smoothing mechanism of the liquid photosensitive resin for laser engraved layer, a part of the active beam reaches the smoothing mechanism, the liquid photosensitive resin on the doctor blade is partially light-cured, and a defect is caused in the application layer. Also, at a boundary (seam) between a spiral rectangular application layer and an adjacent application layer, the application layers are brought into contact with each other by fluidization of the liquid photosensitive resin, and air bubbles are generated, which causes a deficit portion in the vicinity of the resin cured layer surface. Moreover, there are a problem of generation of air bubbles since an extra of the liquid photosensitive resin applied from an application head on the sleeve outer circumferential surface is brought into contact with the doctor blade and accumulated on the blade, and a defect of uneven application or air bubbles in the applied photosensitive resin layer is caused unless a sufficient amount of the photosensitive resin liquid is accumulated in a predetermined application width on the doctor blade till the end of the application since the accumulated photosensitive resin liquid is applied on the printing sleeve again. This resin amount is found out in experiments by the present inventor to be required approximately 1.5 times or more of the resin amount applied on the printing sleeve as described in the above Patent Document 8, and an extra photosensitive resin not applied is wasted, which raises a manufacturing cost. In addition, there are also some problems in practical realization such as generation of air bubbles at the blade tip portion when a shutter is closed, the tackiness or greasiness on the surface since it is difficult to completely remove uncured photosensitive resin remaining on the resin cured layer surface in a post-forming processing mechanism using an adsorption phenomenon by an unwoven cloth, and poor printing quality due to absence of the cushion layer.

In the above Patent Documents 10 and 11, examples of a method of applying the liquid photosensitive cushion resin containing a thermally expanding microcapsule on the outer circumferential surface of the cylindrical support body may include a spray-coating method, a blade-coating method, a gravure-coating method, a reverse-roller coating method, kiss-touch coating method, high-pressure air-knife coating method and the like. The spray-coating method and the high-pressure air-knife coating method are methods called spray coating and capable of forming a seamless-manner application layer, but since only the liquid photosensitive resin with low viscosity or the liquid photosensitive resin diluted by a solvent to lower the viscosity can be applied, the application thickness becomes small and there are problems such as difficulty in obtaining a required thickness as a cushion layer or odor and pollution in the case of dilution by the solvent.

With the blade-coating method, at a moment when the blade distal-end edge and the resin applied on the sleeve outer circumferential surface are separated from each other, there is a problem that the liquid resin held on the plate side is transferred to a part of the liquid resin layer whose application thickness has been already made uniform, which causes defects of uneven application thickness or a projecting portion due to the tackiness of the liquid resin and leads to loss of smoothness. The gravure-coating method and the reverse-roller coating method are methods called roll coating, and similarly to the above spray coating method, the application thickness becomes small since application can be made only by the low-viscosity liquid photosensitive resin or the liquid photosensitive resin diluted by the solvent to lower the viscosity. Thus, there are problems such as difficulty in increasing the thickness up to the thickness required as the cushion layer and odor and pollution in the case of dilution by the solvent.

Also, at a moment when the roll is separated from the resin applied on the sleeve outer circumferential surface, there is a problem that the liquid resin held on the roll side is transferred to a part of the liquid resin layer whose application thickness has been already made uniform, which causes defects of uneven application thickness and a projecting portion, and which leads to loss of smoothness. It is not clear what kind of coating method specifically the kiss-touch coating method is since there is no description in the specification, but judging from the contents of the specification, such problems are expected that, similarly to the above methods, since only the low-viscosity liquid photosensitive resin or the liquid photosensitive resin diluted by the solvent to lower the viscosity can be applied, the application thickness is made small and a required thickness as the cushion layer can not be obtained or odor and pollution in the case of dilution by the solvent.

The present invention has been made in view of the above circumstances and has an object to provide a manufacturing method and a manufacturing device that can manufacture a cylindrical printing substrate with high printability having highly accurate thickness and surface smoothness suitable for printing with a required minimum amount of a photosensitive resin and promote improvement of workability, resource saving and environmental preservation through elimination of a conventional negative film fabrication step and solution developer step.

### Means for Solving the Problems

As the result of keen study in order to achieve the above object, the inventor has obtained a finding that when a thickness of a spiral coating layer obtained by applying a photosensitive resin on a sleeve, which is a cylindrical support body, by a spiral coating method is to be regulated, the above problem can be solved by bringing a doctor blade into contact from below the cylindrical support body and after the regulation of the application layer thickness, and by separating the doctor blade downward and has completed the present invention. That is, the present invention is as defined in present apended claims.

According to the manufacturing method of the present invention, when the doctor blade is brought into contact from below the spiral coating layer, the resin bank is formed between the doctor blade and the spiral coating layer, while when the doctor blade is separated downward, the resin bank is separated together with the doctor blade, and there is no such event that the resin is transferred to the spiral coating layer so as to cause defects such as uneven application thickness and projecting portion and to lead to loss of smoothness on the application layer but the thickness of the application layer can be adjusted evenly.

### Advantages of the Invention

According to the present invention, a cylindrical printing substrate having a smooth photosensitive resin cured layer with a uniform application thickness of the photosensitive resin and less surface steps can be obtained. Also, according to the present invention, since the application liquid surface is smoothed by the doctor blade, abnormal thickness or fluctuation of thickness occurring in the application step can be corrected, and by recovering and reusing the scraped-off application liquid, cost reduction or resource saving of the cylindrical printing substrate can be realized.

### Best Mode for Carrying Out the Invention

A best mode for carrying out the invention for putting the present invention into practice (hereinafter referred to as "the present embodiment") will be described below in detail. The present invention is not limited to the following embodiment but can be put into practice in many forms as long as its gist is not departed.

The term "cylindrical support body" includes a cylinder, a sleeve (hollow cylindrical support body) and the like. A material and the like of the cylindrical support body are not particularly limited, but a sleeve is preferable from the viewpoint of weight saving and easiness in workability. As a material of the sleeve, metal such as nickel, iron, aluminum and the like and fiber reinforced plastics reinforced by glass fiber, carbon fiber, plastic fiber and the like are available. The sleeve is used in a printing step usually in a state attached to an air cylinder. Particularly, as the cylindrical support body, the sleeve is preferably attached to an outer circumferential surface of a mandrel and integrated therewith, and has its strength reinforced in order to hold a cylindrical shape.

As a aspect of the cylindrical printing substrate, a structural body is preferable that a laser engraved resin cured layer made of a cushion resin cured layer and/or a photosensitive resin cured substance obtained from a photosensitive resin, which will be described later, is formed and integrated on a surface of the cylindrical support body such as a cylinder, a sleeve and the like. Also, between the cylindrical support body and the cushion resin cured layer, between the cylindrical support body and the laser engraved resin cured layer, or between the cushion resin cured layer and the laser engraved resin cured layer, an adhesive layer or a tacking agent layer (hereinafter collectively referred to simply as an "adhesive layer") may be present. It is needless to say that on the cushion resin cured layer formed on the cylindrical support body, a printing original plate made of a sheet-like photosensitive resin on which a pattern can be formed or a printing plate made of a sheet-like photosensitive resin cured layer on which a pattern is formed on its surface may be attached for use.

The term "printing substrate" means a material used in the printing field and used for a printing plate, a blanket, a cushion and the like. The printing plate can be used as a printing plate of a flexographic printing plate, a gravure printing plate and the like. Also, it can be used as a cushion in the flexographic printing and a blanket in the offset printing. Particularly, the manufacturing method according to the present embodiment exerts an excellent effect as a method of manufacturing a printing substrate made of a liquid photosensitive resin or moreover, a cushion layer, an adhesive layer, and a substrate for laser engraving made of the liquid photosensitive resin.

Particularly, in a method in which a printing-plate surface is directly in contact with a surface of a substrate to be printed and ink on the printing-plate surface is transferred, as in the flexographic printing method, a cushion layer for alleviating an impact is preferably present. In a conventional art a sheet-like cushion tape having a double-sided adhesive layer on both faces of a cushion layer is affixed on the surface of the cylindrical support body, and moreover, the sheet-like printing plate is affixed thereon. When the cushion tape is to be affixed on the cylindrical support body, careful work is required so as not to involve air bubbles. Also, when the cushion tape is to be affixed, a seam is generated at both end portions of the cushion tape without a fail, and since the seam portion appears in a line state on the printed matter, there is a problem that the quality of the obtained printed matter is extremely lowered. This line-state printing defect is a phenomenon which appears more remarkably if printing pressure is set higher at printing. Therefore, in view of ensuring the printing quality, it is preferable that the printing substrate according to the present embodiment does not have a seam (seamless). In the case of the printing original plate in which a printing layer is formed on the adhesive layer or the cushion layer, the adhesive layer or the cushion layer is preferably seamless, and the above effect is exerted even if the printing layer formed on these layers is not seamless. Examples of such a substrate include a sheet-like printing plate affixed on a seamless cushion layer.

The term "printing layer" means a photosensitive resin layer or a photosensitive resin cured layer on which an irregular pattern can be formed on the surface or a photosensitive resin cured layer on which the irregular pattern is formed on the surface. If the printing substrate has the printing layer, a preferable aspect of the printing substrate may include a cushion layer/printing layer, a sleeve/cushion layer/printing layer, a sleeve/adhesive layer/cushion layer/printing layer and the like.

The manufacturing method according to the present embodiment (hereinafter referred to "the present manufacturing method") is a method of manufacturing a cylindrical printing substrate containing a photosensitive resin cured layer, comprising the steps of:
(i) forming a spiral coating layer (spiral application layer) by applying a photosensitive resin on a cylindrical support body by a spiral coating method (spiral application method);
(ii) forming an application layer made of the spiral coating layer having a uniform surface by bringing a doctor blade (plate thickness regulating plate) into contact with the spiral coating layer and by having the spiral coating layer pass through a gap formed between the doctor blade and an outer circumferential surface of the cylindrical support body and then, separating the doctor blade from the application layer;
(iii) forming a photosensitive resin cured layer by light-curing the application layer, in which the doctor blade is brought into contact with the spiral coating layer from below the cylindrical support body and then, the doctor blade is separated downward.

In the present manufacturing method, by employing the above step (i), an application width can be easily changed according to various printing widths, and an effect is exerted that application can be made on a cylindrical support body which is long in the width direction. Here, the spiral coating method means spiral application on the cylindrical support body while a predetermined width of resin is discharged in a ribbon state.

As the photosensitive resin, a photosensitive resin composition which is solid at 20°C can be used in addition to the photosensitive resin composition which is liquid at 20°C, but in that case, it is necessary to melt the photosensitive resin composition at a high temperature and to carry out push-out application. Also, a photosensitive resin composition which is solid at 20°C formed in a ribbon state can be spirally wrapped on the cylindrical support body, but it is necessary to weld its end at a high temperature, and a calendar processing for making the thickness uniform is also a required processing. From the viewpoint of easiness in application and forming, the resin which is liquid at 20°C is preferable.

In the present manufacturing method, by employing the above step (ii), the thickness of the spiral coating layer formed in the step (i) can be made uniform, and by having it follow the irregularity on the surface of the cylindrical substrate, an effect that close contact between the cylindrical support layer and the spiral coating layer can be improved and the like. Moreover, from the viewpoint that the extra application liquid can be held, the doctor blade is brought into contact from below the cylindrical support body. Here, the below is preferably lower than the central axis of the cylindrical support body or preferably immediately below the shaft center of the cylindrical support body. If the distal end portion of the doctor blade has a taper shape (inclined shape), so that the (liquid) photosensitive resin accumulated in the taper portion (inclined portion) does not drop down, the resin bank can be formed by adjusting a rotating speed of the sleeve according to viscosity of the (liquid) photosensitive resin, and the extra amount of the application liquid of the spiral coating layer can be minimized, which is highly economical. Also, formation of the resin bank at the distal end portion of the doctor blade is preferable since the problem of a joint where a region in which the application liquid is not uniformly applied in the spiral application step is spirally observed and the problem of air bubbles caused in the case of recoating in order to eliminate the joint can be solved.

Next, when the doctor blade is separated from the application layer made of the spiral coating layer downward, the doctor blade and the resin bank can be separated from the application layer substantially at the same time. If the doctor blade is separated at a low speed such as from 0.5 to 5 mm/min, for example, at the separation, at a moment when the doctor blade is separated from the application layer on the sleeve, due to the tackiness of the liquid photosensitive resin, which will be described later, the resin bank can be separated together with the doctor blade. Therefore, the problem that the liquid photosensitive resin held by the doctor blade is transferred to a part of the application layer whose application thickness has been already made uniform, which causes defects of uneven application thickness or projecting portion, and which leads to loss of smoothness can be drastically improved. Also, if a high-viscosity resin is used on the outer circumferential surface of the sleeve, a layer made of the (liquid) photosensitive resin can be formed in the seamless manner, which is preferable.

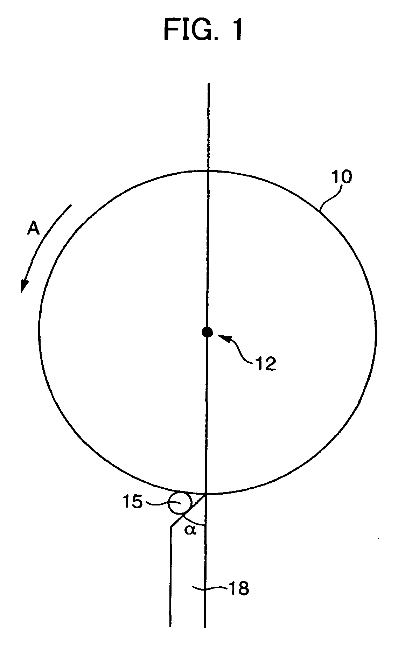

Figure 1 shows a sectional outline diagram for explaining a relation between a sleeve 10, which is a cylindrical support body, and a doctor blade 18. Using a case where the doctor blade 18 is disposed along the vertical direction from a shaft center 12 of the cylindrical support body 10, a resin bank 15 formed at a distal end portion of the doctor blade 18 is described. In the present embodiment, the doctor blade 18 preferably has its distal end portion in contact with the photosensitive resin (not shown in Figure 1) in the taper shape. As a result, on an inclined face in the taper shape, the resin bank 15 made of the extra photosensitive resin can be formed between the doctor blade 18 and the sleeve 10, and by presence of the resin bank 15, the spiral coating layer can be uniformly distributed on the outer circumferential surface of the sleeve 10. The inclined face in the taper shape preferably has a height on the side closer to a rotating direction (arrow A in Figure 1) of the sleeve 10 lower than that on the side farther in the rotating direction for formation of the resin bank 15 with respect to the rotating direction of the sleeve 10. That is because since the photosensitive resin is received in the taper shape along the rotating direction of the sleeve, the resin bank is preferably formed before the distal end portion so that the photosensitive resin can be uniformly distributed on the sleeve 10.

As mentioned above, the resin bank 15 itself formed in such a manner is a highly-viscous photosensitive resin, and when the doctor blade 18 is separated downward, the resin bank 15 is also separated downward together with the doctor blade 18. At that time, an angle α between the vertical direction from the shaft center of the sleeve and the inclined face in the taper shape is preferably from 30 to 75°, more preferably from 30 to 60°, further preferably from 40 to 50°, the most preferably 45°. If the angle α is 30° or more, the resin bank 15 tends to be held on the inclined face of the doctor blade 18. On the other hand, if the angle α is 75° or less, the resin bank 15 present on the doctor blade 18 does not obstruct rotation of the sleeve 10 but can form a smooth application surface on the sleeve 10.

In the present manufacturing method, after the above step (ii), the application layer is light-cured in the step (iii). As mentioned above, in the conventional art in which light-curing is carried out at the same time as smoothing, the active beam reaches the smoothing mechanism and gives a defect in the application layer. On the other hand, in the present embodiment, since the step of smoothing the photosensitive resin (step (ii)) and the step of light-curing (step (iii)) are separated from each other, the above trouble can be reduced.

One of the preferable aspects of the present manufacturing method is a method of manufacturing a cylindrical printing substrate in which the cylindrical printing substrate has the printing layer provided on the adhesive layer and/or the cushion layer, in which the adhesive layer and/or the cushion layer is formed by the above steps from (i) to (iii), the printing layer is a photosensitive resin layer or the photosensitive resin cured layer in which the irregular pattern can be formed on the surface or the photosensitive resin cured layer in which the irregular pattern is formed on the surface. If the cylindrical printing substrate is provided with the adhesive layer and the cushion layer, by carrying out the above steps from (i) to (iii) using the photosensitive resin for adhesive layer and then, by carrying out the above steps from (i) to (iii) using the photosensitive resin for cushion layer, the cylindrical printing substrate provided with the adhesive layer and the cushion layer can be manufactured.

Here, the term "photosensitive resin layer in which the irregular pattern can be formed on the surface" refers to a photosensitive resin layer in which an irregular pattern can be formed on the surface using a photoengraving art. Also, the term "photosensitive resin cured layer in which the irregular pattern can be formed on the surface" refers to a photosensitive resin cured layer in which the irregular pattern can be formed on the surface using a laser engraving method. The photosensitive resin layers in which the irregular pattern can be formed on the surface may include a composition in which a thermoplastic elastomer such as a styrene-butadiene-styrene (SBS), styrene-isoprene-styrene (SIS) and the like is mixed with a monomer component, a plasticizer component, a photopolymerization initiator and the like, for example. Such a composition can be formed in a sheet state and laminated on the cylindrical printing substrate as a photosensitive resin layer. Also, after the exposure step using an exposure mask, a pattern can be formed on the surface through a development step for developing and removing an uncured portion by a developer or a thermal development step for heating and melting the uncured portion with an unwoven cloth and the like to be absorbed and removed. In this case, a step of fuse-bonding an end of the sheet-like photosensitive resin layer laminated on the cylindrical printing substrate so as to remove a joint may be gone through.

Also, as the photosensitive resin cured layer in which the irregular pattern can be formed on the surface, a sheet-like photosensitive resin cured layer obtained by light-curing a photosensitive resin layer obtained by forming a photosensitive resin composition having the above-mentioned thermoplastic elastomer as a constituent component is formed in a sheet state is laminated on the cylindrical printing substrate , or the sheet-like photosensitive resin layer is laminated on the cylindrical printing substrate still in the sheet-state and then, light-cured, so that a photosensitive resin cured layer can be obtained and can be used as a printing layer in the printing step. If it is formed cylindrically in an uncured state, a joint can be removed by welding the sheet ends. Moreover, the example materials useful for forming a photosensitive resin cured layer in which the irregular pattern can be formed on the surface using the laser engraving method may include a liquid photosensitive resin composition at 20°C made of a composition in which a prepolymer such as unsaturated polyurethane, unsaturated polyester and the like is mixed with a monomer component or photopolymerization initiator. The liquid photosensitive resin components described above is applied on the cylindrical printing substrate and then, cured by light to be used as the photosensitive resin cured layer and can made into the printing layer in which the pattern is formed on the surface by the laser engraving method.

Moreover, the photosensitive resin cured layer in which the irregular pattern is formed on the surface refers to a sheet-like photosensitive resin cured layer in which the irregular pattern is formed on the surface by photoengraving art, laser engraving method and the like. Examples may include a photosensitive resin cured layer made of a photosensitive resin composition formed in a sheet state and having the thermoplastic elastomer as a constituent component having gone through the exposure and development steps in the sheet state and a pattern is formed on the surface and moreover; the photosensitive resin cured layer made of a photosensitive resin cured substance formed in the sheet state in which a pattern is formed on the surface by the laser engraving method. These photosensitive resin cured layers can be laminated on the cylindrical printing substrate, and used in the printing step as the printing layer. Therefore, a method of forming these printing layers on the cushion layer is not particularly limited, and examples may include methods such that the photosensitive resin layer or photosensitive resin cured layer formed in the sheet state is affixed on the cushion layer via the adhesive layer; the liquid laser photosensitive resin composition is applied on the cushion layer by a blade-coating method or a push-out method, different from the spiral coating method and the like. Here, the liquid state includes the photosensitive resin composition heated and molten to be liquidized.

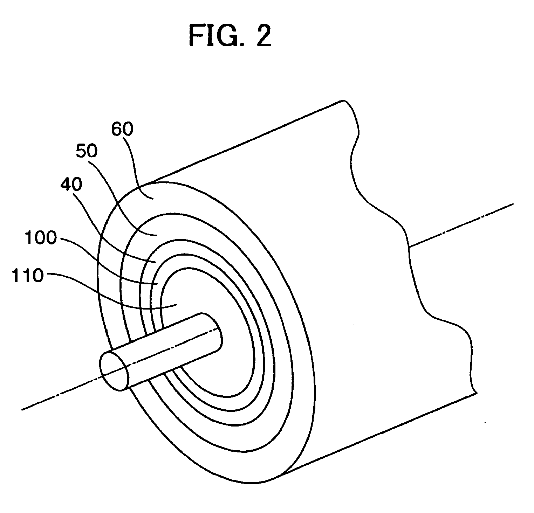

Figure 2 shows an outline sectional diagram of the cylindrical printing substrate obtained by the present manufacturing method having a three-layered structure (adhesive layer 40/cushion layer 50/laser engraved resin layer 60). In Figure 2, the three-layered structure (adhesive layer 40/cushion layer 50/laser engraved resin layer 60) attached to a mandrel 110 which will be described later by a manufacturing device and formed on the sleeve 100 is schematically shown.

If both the adhesive layer and the cushion layer are provided, light-curing of each layer (step (iii)) may be carried out separately, or may be carried out at the same time after the cushion layer is formed on the adhesive layer. Moreover, it may be carried out at the same time as the light-curing of the photosensitive resin after the printing layer made of the photosensitive resin is formed on the cushion layer. Among them, since a problem of lack of exposure of the adhesive layer due to rapid reduction in light beam permeability in the cushion layer, a problem that the cushion resin liquid is not cleanly applied on the liquid adhesive layer due to a difference in viscosity between the adhesive and the cushion resin, and a problem that the laser engraving resin liquid is not cleanly applied on the similarly liquid cushion resin layer can be prevented, the method of lamination after sequential curing of each layer is preferable.

Also, in the above preferred mode, viscosity of the liquid photosensitive resin constituting the adhesive layer and/or the cushion layer is 6 Pa·s or more and 50,000 Pa·s or less at 20°C, preferably 100 Pa·s or more and 20,000 Pa·s or less and more preferably 200 Pa·s or more and 10,000 Pa·s or less. By having the viscosity of 6 Pa·s or more, the resin bank made of a photosensitive resin can be easily separated from the application layer with the doctor blade, while if the viscosity is 50,000 Pa·s or less, when the extra application liquid is scraped off, an extra burden is not applied on the doctor blade and nonconformity hardly occurs in operability of the doctor blade itself.

The ultraviolet ray in the exposure step preferably has a wavelength region of from 200 t 400 nm and ultraviolet intensity of 10 mW/cm² or more, since the ray is not affected by gravity and centrifugal force by rotation, and an application shape can be maintained. Also, by using the ultraviolet ray with a wavelength region of from 200 to 400 nm and ultraviolet intensity of 10 mW/cm² or more for exposure of the liquid photosensitive resin, a photosensitive resin cured layer with improved printability can be formed, and since the photosensitive resin cured layer can be engraved by an infrared laser with a wavelength region of from 0.7 to 15 micrometer, which is preferable. As mentioned above, by improving the printability of photosensitive resin cured layer by irradiating a high-intensity ultraviolet ray, notch resistance is improved by twice or more than a low-intensity fluorescent-lamp ultraviolet light source and the layer becomes resistant against chipping, hardness is lowered approximately by 5 degrees by Shore A, and holding of solid ink is improved, which is also preferable.

Moreover, in the above preferred aspect, the cushion layer preferably contains a gas (air, oxygen, nitrogen, helium and the like) contained in a microcapsule. According to this method, in a method in which the air bubbles are introduced by stirring the liquid photosensitive resin and the light-cured product is used as a cushion layer, a problem of thickness change over time due to lack of stability of the air bubbles can be solved. Particularly, it is preferable that the microcapsule is a thermally expanding microcapsule, and the microcapsule is thermally expanded in advance and mixed and uniformly distributed in the liquid photosensitive cushion resin in a predetermined weight ratio, and it is applied as the liquid photosensitive cushion resin containing air bubbles in the cushion resin application step. According to this method, since the microcapsules are uniformly distributed in the cushion resin, the cushion characteristics are favorable, and since a cushion resin cured layer in a seamless manner can be formed, a stable cushion effect can be obtained at printing.

In the above preferred aspect, if the printing layer is a photosensitive resin layer in which an irregular pattern can be formed on the surface, in the step of applying the photosensitive resin, it is preferable to further include a step in which while the extra application liquid is scraped off by the doctor blade and the application layer surface is smoothed, the scraped-off application liquid is recovered. This method is preferable in a point that the smooth printing layer with a uniform application thickness can be formed on the cylindrical support body outer circumferential surface and the resin scraped off by the doctor blade can be recovered and reused as the liquid photosensitive resin.

As mentioned above, according to the manufacturing method of the present embodiment, a cylindrical printing substrate having a cushion layer suitable for printing and high printability realized by highly accurate thickness and surface smoothness, and having no seam, can be manufactured. Moreover, a complicated manual work such as affixation of a double-sided adhesive cushion tape on an outer circumferential surface of the cylindrical support body and affixation of a sheet-like solid plate on the adhesive layer without a wrinkle or accumulated air, and a problem of defective printing caused by a seam of the double-sided adhesive cushion tape are solved, and effects are provided such as improvement of workability by eliminating the conventional negative film fabrication step or solution developer step, resource saving and environmental preservation.

A manufacturing device that can embody the method of manufacturing the cylindrical printing substrate, which is another aspect as the present embodiment, is described below using the drawings, but the present invention is not limited by the following.

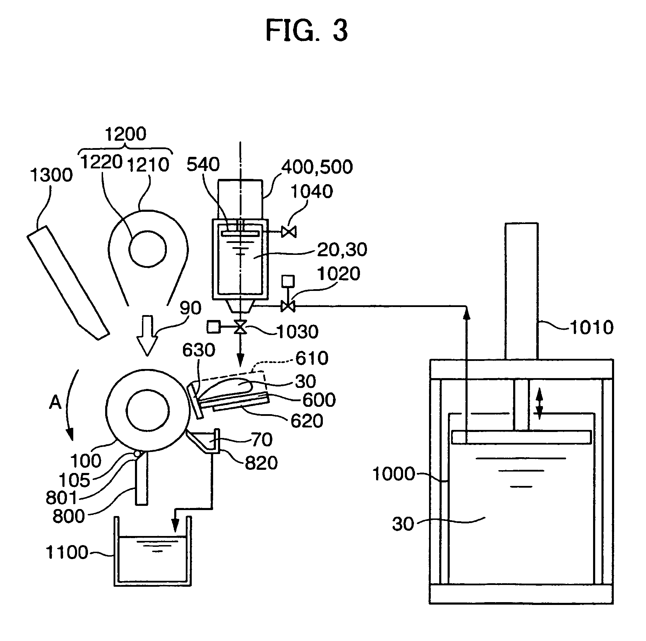

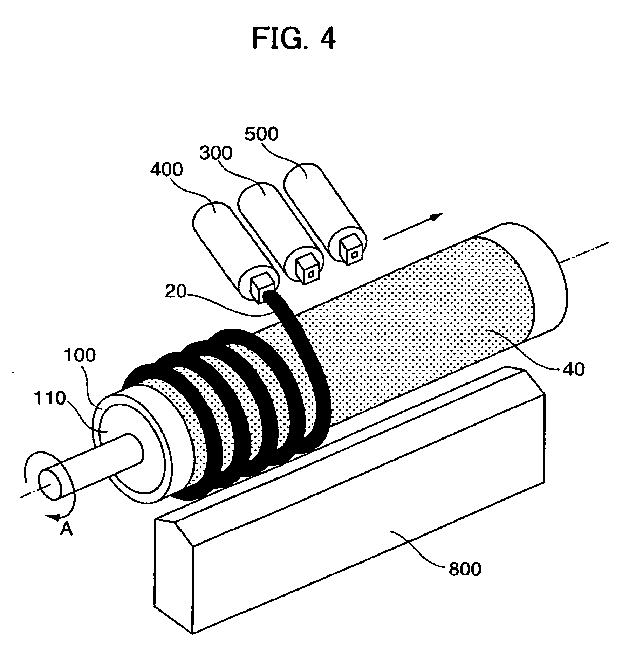

Figure 3 shows a side schematic diagram for explaining outline configuration of the device for manufacturing the cylindrical printing substrate according to the present embodiment (hereinafter referred to as "the present manufacturing device"). Figure 4 is an outline diagram for explaining the spiral coating step in the present manufacturing method. In Figure 3, a cushion resin dispenser 400 and a laser engraved resin dispenser 500, and a liquid photosensitive cushion resin 20 and a liquid photosensitive laser engraved resin 30 are shown as the same members, but they may be manufactured using another dispenser and resin, respectively.

Figure 3 shows an example of the present manufacturing device. As an example of the present manufacturing device, a sleeve 100 as the cylindrical support body on which the photosensitive resin is applied, the dispenser 400 for discharging the photosensitive resin on the sleeve 100, and a doctor blade 800 disposed below the sleeve 100 and having a taper shaped distal end portion are provided. In the present manufacturing device, while the sleeve 100 is rotated, the photosensitive resin is applied from the dispenser 400 on the sleeve 100 so as to form the spiral coating layer. Next, by bringing the doctor blade 800 into contact with the spiral coating layer from below the sleeve 100, and then, by separating the doctor blade 800 downward, the cylindrical printing substrate having the cushion resin layer is manufactured using the photosensitive resin. Also, in Figure 3, the liquid photosensitive resin is described using the cushion resin dispenser 400, but an adhesive dispenser 300 and the laser engraved resin dispenser 500 may also be provided. Moreover, the present manufacturing device is also provided with an exposure unit 1200 disposed above the sleeve 100 so that the cushion resin layer formed as above is light-cured and the cushion resin cured layer can be formed.

When being explained in more detail using Figure 3, on an outer circumferential surface of the thin sleeve 100 for printing attached and integrated on a mandrel 110, the liquid photosensitive adhesive is applied in a uniform thickness in a seamless manner by a spiral coating method using the dispenser, and light-cured by exposure from the exposure unit 1200 so that an adhesive cured layer 40 is formed.

Next, on the adhesive cured layer, the liquid cushion resin 20 is supplied from the cushion resin dispenser 400. In Figure 3, the cushion resin dispenser 400 is arranged on the right side to the sleeve 100, but the dispenser 400 can be moved immediately above the sleeve 100 so that the liquid photosensitive cushion resin 20 is directly supplied from the dispenser 400 to the sleeve 100 by the spiral coating method. Specifically, by the spiral coating method, while the sleeve 100 is rotated in a direction of an arrow A in Figure 4, the liquid photosensitive cushion resin 20, which is a compressive fluid, is applied in a uniform thickness in a seamless manner with a slight gap so that seams are not overlapped. After that, the rotating speed of the sleeve 100 is switched to a high-speed rotation according to the viscosity of the liquid photosensitive cushion resin, the doctor blade 800 having a taper shaped distal end portion is pressed onto the cushion resin 20, and by a scraped-off extra resin, a resin bank 105 is formed at the taper shaped portion of the doctor blade 800. At that time, the doctor blade 800 can make the thickness of the cushion resin 20 forming the spiral coating layer on the sleeve 100 uniform, and by having the irregularity on the surface of the sleeve 100 followed, close contact between the sleeve 100 and the resin 20 can be improved. As exemplified in Figure 3, since the doctor blade 800 is brought into contact with the resin 20 from below the sleeve 100 and has its distal end portion in the taper shape, the extra resin liquid can be maintained as the resin bank 105 using an inclined face of the taper shaped portion. The inclined face of the taper shaped portion preferably has a height on the side closer to a rotating direction (arrow A in Figure 1) of the sleeve 100 lower than that on the side farther from the rotating direction for formation of the resin bank 105 to the rotating direction of the sleeve 100. The resin bank 105 can be re-applied on the cushion resin 20 forming the spiral coating layer and make the thickness of the surface of the application layer made of the cushion resin layer uniform by continuing rotation of the sleeve 100. After that, by separating the doctor blade 800 from the cushion resin layer downward at a low speed, the resin bank 105 can be separated from the cushion resin layer together with the doctor blade 800. Subsequently, light-curing is carried out by exposure from the exposure unit 1200 so as to form the cushion resin cured layer 50.

The doctor blade 800 exemplified in Figure 3 shows an example that in the inclined face in the taper shape, the height on the side closer to the rotating direction (arrow A in Figure 1) of the sleeve 100 is lower than that on the side farther from the rotating direction. On the other hand, as exemplified in Figure 4, the doctor blade 800 in which two doctor blades exemplified in Figure 3 are overlapped symmetrically right and left can also be used in the present embodiment.

Subsequently, the sleeve 100 is rotated in the opposite direction and the rotating speed is switched to a low speed, and on the cushion resin cured layer 50, the liquid photosensitive laser engraved resin 30 is applied in a uniform thickness in a seamless manner and so that defects such as air bubbles do not occur in an image portion through a resin application smoothing unit 600 by a doctor coating method. At that time, as exemplified in Figure 3, the resin application smoothing unit 600 can supply, with a resin fluidization preventing weir 610 and a coating shutter 630, the photosensitive laser engraved resin 30 with a predetermined application width to be applied to the sleeve 100. After that, the doctor blade 800 is brought into contact with the applied laser engraved resin 30 so that the surface of the laser engraved resin layer is made to have a more uniform thickness. After that, the doctor blade 800 is separated downward from the laser engraved resin layer.

After that, by the exposure from the exposure unit 1200, by forming the laser engraved resin cured layer 60 on the cushion resin cured layer 50, the cylindrical printing substrate in the seamless manner is completed.

In the above example, the example in which curing of each layer by exposure is sequentially conducted was explained, but the light-curing may be conducted at the same time. That is, it is also possible that the liquid photosensitive adhesive is applied, the liquid photosensitive cushion resin is applied on the liquid photosensitive adhesive layer, the liquid photosensitive laser engraved resin is applied on the liquid photosensitive cushion resin layer, and after all the application steps are finished, simultaneous exposure is conducted. Alternatively, it is also possible that the liquid photosensitive adhesive is applied, the liquid photosensitive cushion resin is applied on the liquid photosensitive adhesive layer, and after the application steps of the two layers are finished, simultaneous exposure is conducted, the liquid photosensitive laser engraved resin is applied on the cushion resin cured layer so as to conduct exposure.

Alternatively, after the liquid photosensitive adhesive is applied and the adhesive cured layer is formed by exposure, it is possible to apply the liquid photosensitive laser engraved resin on the adhesive cured layer and conduct exposure without forming the cushion layer. Moreover, it is also possible that after the liquid photosensitive cushion resin is directly applied without through the adhesive layer on the sleeve, which is the cylindrical support body, and the cushion resin cured layer is formed by exposure, the liquid photosensitive laser engraved resin is applied on the cushion resin cured layer and exposure is conducted.

In another aspect of the present manufacturing device, a device for manufacturing a cylindrical printing substrate using a photosensitive resin is provided, comprising an online attachment/detachment mechanism of sleeve; a mechanism of connecting the sleeve or a mandrel with the sleeve for detecting rotation and a rotating angle; a dispenser application mechanism having a function to house a cartridge containing the photosensitive resin, a temperature control function to control a temperature of the photosensitive resin, a constant-amount discharge function to discharge a constant amount of the photosensitive resin, a thickness regulating function to regulate the thickness of the photosensitive resin, an elevation function, an advancing/retreating function and a linear moving function in a shaft center longitudinal direction of the sleeve; a doctor blade disposed below the sleeve and having a blade tip having a blade edge with a taper shape on one side and a function to detect elevated and height positions; a recovering mechanism for recovering an application liquid of the photosensitive resin scraped off by the doctor blade; an application mechanism having a dam function and supply means of the photosensitive resin; and an ultraviolet irradiation mechanism for irradiating an ultraviolet ray to the application liquid of the photosensitive resin applied on the sleeve outer circumferential surface, in which the photosensitive resin is applied from the dispenser application mechanism on the sleeve so as to form a coating layer, the doctor blade is brought into contact with the coating layer from below the sleeve, and then, the doctor blade is separated downward.

According to this configuration, since while thickness fluctuation of the application layer applied on the outer circumferential surface of the sleeve is corrected, the resin liquid scraped off by the doctor blade from below the sleeve can be recovered and reused, a cylindrical printing substrate having a cushion layer with highly-accurate thickness and suitability for printing and surface smoothness can be easily manufactured. Also, since the present manufacturing device can automatically replenish the application liquid, an application liquid containing mechanism (such as a tank, a drum, a pail and the like) having a liquid-feed function and a temperature control function and a piping and an electromagnetic valve for supplying the application liquid to the dispenser application mechanism or application mechanism are preferably further provided. Moreover, the present manufacturing device is preferably further provided with a mixer mechanism for uniformly mixing and distributing the microcapsule in which a gas is contained in the liquid photosensitive cushion resin. That is because, with this configuration, since the microcapsules are uniformly distributed in the cushion resin, the cushion resin cured layer with favorable cushion characteristics and in the seamless manner can be formed.

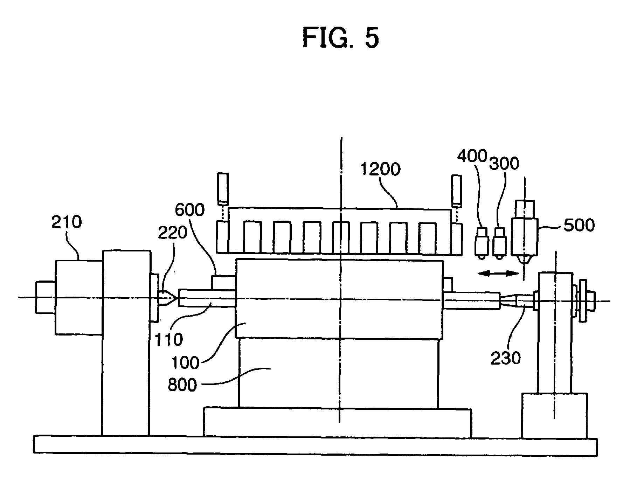

Figure 5 shows a schematic diagram for explaining outline configuration of the device for manufacturing the cylindrical printing substrate according to the present embodiment. As shown in Figure 5, the sleeve 100 is attached on the outer circumferential surface of the mandrel 110. The mandrel 110 is connected to a main-shaft spindle 220 by a tailstock 230, and a rotation connecting pin 260 is inserted into a notch portion for rotation transmission of a mandrel hub 270. A mechanism for detecting rotation and a rotating angle by connecting the sleeve 100 or the mandrel with sleeve is integrated with a rotation control mechanism 210 provided with an encoder for detecting rotation driving and a rotating angle. Though the doctor blade 800 can not be used any more, a tailstock advancing/retreating mechanism capable of lateral movement according to a width of the mandrel 110 is provided at the tailstock 230. In Figure 5, with respect to the sleeve 100, the adhesive dispenser 300 movable in its shaft center direction, the cushion resin dispenser 400, and the laser engraved resin dispenser 500 are disposed. When the photosensitive resin from the dispensers 300, 400 is applied on the sleeve 100, it is possible to directly supply the photosensitive resin from the dispensers 300, 400 to the sleeve 100 by the spiral coating method. On the other hand, if the photosensitive laser engraved resin 30 supplied from the dispenser 500 is applied, in order to prevent occurrence of defects such as air bubbles, a predetermined amount of the photosensitive resin can be supplied to the sleeve 100 using the resin application smoothing unit 600.

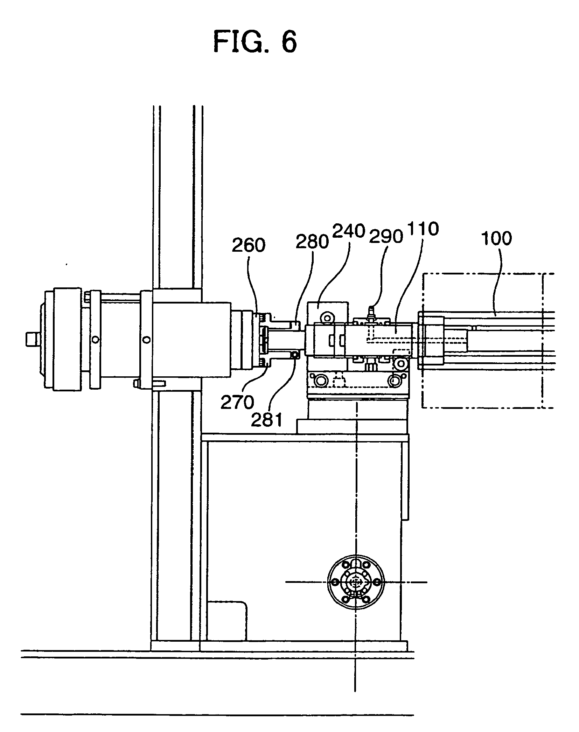

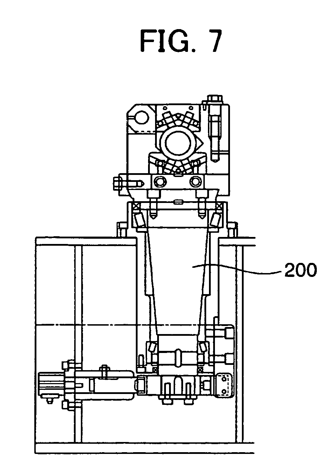

Figure 6 is a partially assembled diagram illustrating outline configuration of a mandrel connecting rotating mechanism in the device for manufacturing the cylindrical printing substrate according to the present embodiment. Figure 7 is a right-side partial assembly diagram illustrating the outline configuration of the mandrel connecting rotating mechanism in the device for manufacturing the cylindrical printing substrate according to the present embodiment. The online attachment/detachment mechanism of the sleeve in the present manufacturing device is described referring to Figures 6 and 7. In order that the sleeve 100 can be easily attached to and removed from the mandrel 110 (metal mandrel), a left-side journal of the mandrel 110 is sandwiched by a split-type bearing 240 in a cantilever manner, and in the sandwiching portion, a cantilever-sandwiching swivel table 200 capable of 30° swing of the mandrel 110 to the front side is provided at a fulcrum.

Before start of the plate making, the swivel table 200 is operated to move the mandrel 110 to a position swung by 30° (attachment and removal position of the sleeve 100), and the sleeve 100 is attached while a compressed air is supplied to the mandrel 110 from a compressed-air injection piping system 290. Subsequently, the swivel table 200 is operated to return the mandrel 110 with the sleeve 100 to a rotation standby position, a mandrel support table is raised, and the main-shaft spindle 220 is advanced so as to maintain the left-side journal of the mandrel 110. After that, the mandrel hub 270 is manually rotated to a position where the notch portion for rotation transmission of the mandrel hub 270 matches the rotation connecting pin 260, the tailstock 230 is pushed in according to a width size of the mandrel 110, and a right-side journal of the mandrel 110 is maintained by the tailstock 230 and then, a pressure screw 281 attached to an ETP bush (manufactured by Miki Pulley) 280 is tightened. The mandrel 110 is integrally connected to the rotation driving and rotation control mechanism 210 and brought into the rotation standby state.

The dispenser application mechanism in the present manufacturing device is described. Returning to Figures 3 and 5, the application means of the liquid photosensitive adhesive, the liquid photosensitive cushion resin 20, and the liquid photosensitive laser engraved resin 30 is provided with the dispensers 300, 400, 500 with temperature control function having a function to advance/retreat the dispenser from the standby position to the application position, a traverse mechanism for linearly moving along the sleeve 100 shaft center direction, the height position detection mechanism of the respective application liquid push-out nozzles and elevation function, and a function to enable linear movement in the shaft center longitudinal direction of the sleeve. Also, as the application means of the liquid photosensitive laser engraved resin 30, in addition to the dispenser 500, the resin application smoothing unit 600 is further provided. The dispenser application mechanism in the present manufacturing device is further provided with the cartridge containing function to contain the photosensitive resin and a thickness regulating function that can regulate the thickness of the photosensitive resin to be applied by adjusting a distance between the nozzles of the dispensers 300, 400, 500 discharging a constant amount of the photosensitive resin and the sleeve 100.

The resin application smoothing unit 600 is preferably provided with a resin receiver having an adjustment function of the inclination angle, and is provided with a coating shutter 630 having its distal end machined into a highly accurate doctor blade shape and having an elevation function. Also, the resin application smoothing unit 600 is provided with a resin application smoothing unit advancing/retreating mechanism capable of advancing/retreating toward the sleeve 100; and is provided with a pair of resin fluidization preventing weirs 610 for controlling the application width capable of moving in the shaft center direction of the sleeve 100 and having at least one end which is movable, in order that the temperature-controlled liquid resin 30 supplied in a constant amount from the dispenser 500 by pushing in a plunger 540 at a predetermined speed does not flow exceeding a desired application width; and a mechanism 620 for temperature control of the supplied liquid resin 30. The coating shutter 630 is integrated with the resin receiver in the lowered state and forming the doctor blade for coating, while in the raised state, the resin receiver and the resin fluidization preventing weir 610 form the resin dam and are constructed capable of reserving the liquid photosensitive laser engraved resin. As mentioned above, the application mechanism in the present manufacturing device has the resin application smoothing unit 600, the resin fluidization preventing weir 610 (shown by a dotted line in Figure 3), and the coating shutter 630 integrated so as to form the dam function and the supply means of the photosensitive laser engraved resin.

Also, as exemplified in Figure 3, resin replenish means to the dispenser 500 is preferably provided with a drum 1000 containing the liquid photosensitive laser engraved resin 30, a drum press device 1010 discharging a constant amount of the liquid resin 30, opening/closing electromagnetic valves 1020 and 1030 controlling supply and shut-off of the liquid resin 30, and an air-bleeding valve 1040, and a temperature control mechanism is preferably equipped in a supply path of the liquid resin 30 from the drum 1000 to the dispenser 500 for stabilizing a temperature (final purpose is stability of the viscosity).

In the resin replenishment of the liquid photosensitive laser engraved resin dispenser 500, the air-bleeding valve 1040 is opened, the switching electromagnetic valves 1020 and 1030 are controlled into a resin replenishment state, and then, the liquid resin 30 contained in the drum 1000 is pushed out and fed by the drum press device 1010, and when a resin containing portion of the dispenser 500 becomes full, the air-bleeding valve 1040 is closed, and the switching electromagnetic valves 1020 and 1030 are controlled into a liquid-feed stop state. In the liquid photosensitive adhesive dispenser 300 and the liquid photosensitive cushion resin dispenser 400, a cartridge container containing the liquid photosensitive adhesive and a cartridge container containing the liquid photosensitive cushion resin 20 prepared by uniformly mixing the thermally expanded microcapsule and the liquid photosensitive resin in a predetermined weight ratio by a commercial mixer offline immediately before start of the plate making are loaded, and the cartridge containers are maintained at a predetermined temperature by the temperature control mechanism.

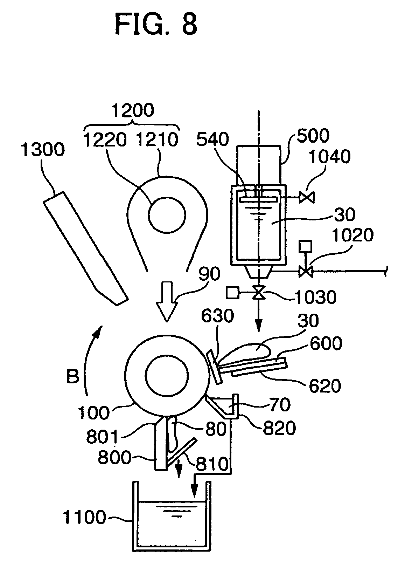

Figure 8 is an outline sectional diagram for explaining the recovery mechanism of the liquid photosensitive resin. As exemplified in Figure 8, the recovery mechanism for bank formation of the liquid photosensitive cushion resin 20 and the liquid photosensitive laser engraved resin 30 is provided with a doctor elevation mechanism provided with position detecting means capable of elevation to a position according to a desired application thickness and an elevation function, the doctor blade 800 provided with a highly accurate distal-end blade having one face 801 in contact with the liquid photosensitive cushion resin 20 in the taper shape and an opposite face in contact with the laser engraved resin 30 perpendicular, a doctor recovered resin gutter 810 with a temperature control function into which a recovered resin 80 flows, an application recovered resin gutter 820 with a temperature control function into which a recovered resin 70 flows, and a pail 1100 for containing the recovered resins 70 and 80. A doctor taper shape 801 of the doctor blade 800 has an inclination angle of preferably from 30 to 75°, more preferably from 30 to 60°, further preferably from 40 to 50°, the most preferably 45° according to the viscosity of the liquid photosensitive cushion resin 20. If the angle α is 30° or more, the resin bank 15 tends to be held on the inclined face of the doctor blade 18. On the other hand, if the angle α is 75° or less, the resin bank 15 present on the doctor blade 18 does not obstruct rotation of the sleeve 10 but can form a smooth application surface on the sleeve 10. When the liquid photosensitive resin is recovered, the liquid photosensitive resin is preferably rotated in a direction opposite to the rotation of application of the liquid photosensitive resin on the sleeve 100 for recovery. Specifically, the direction is opposite to the rotating direction (arrow A) of the sleeve 100 in Figure 3 and the rotating direction (arrow B) of the sleeve 100 in Figure 8, and by rotating in the direction opposite to the application direction, the resin can be recovered efficiently.

As exemplified in Figure 3, the examples of means for exposing the application liquid may include the exposure unit 1200 generating a high-intensity ultraviolet ray. The exposure unit 1200 is provided with the exposure unit advancing/retreating mechanism movable from the standby position to the exposure position and an exposure unit elevation mechanism capable of being elevated according to an outer diameter of the sleeve 100 and is formed by a lamp irradiator 1210 having a micro-wave non-electrode type metal halide lamp 1220.

As a light source generating a high-intensity ultraviolet ray and corresponding to a width of the sleeve 100, the micro-wave non-electrode type metal halide lamp 1220 mainly emitting light in a ultraviolet wavelength region from 200 to 400 nm (nanometer) is exemplified in this embodiment, but according to absorbing spectrum of photosensitizer added to the photosensitive application liquid, those emitting light in an efficient wavelength region such as a high-pressure mercury lamp, super high-pressure mercury lamp, electrode-type metal halide lamp and other high-intensity ultraviolet lamp are preferably selected.

The lamp irradiator 1210 shown in Figure 3 is provided with a lamp 1220, a cold mirror transmitting only a heat ray behind, a heat-ray cut filter for suppressing transmission of the heat ray, and an air-supply fan mechanism and air-exhaust fan mechanism for lamp air-cooling. Also, a sleeve cooling air blower nozzle 1300 for blowing a cool air toward the sleeve 100 during exposure is preferably provided. Moreover, in order to protect regions holding the photosensitive application liquid or recovered resins 70 or 80 such as the dispensers 300, 400, 500, the resin application smoothing unit 600, the doctor blade 800, the doctor recovered resin gutter 810, the application recovered resin gutter 820, a pail 1100 and the like from exposure of an ultraviolet ray 90, the present manufacturing device is provided with two sets of opening/closing type ultraviolet-shielding shutter unit (not shown).

Next, an example of the method of manufacturing a seamless sleeve printing original plate using the present manufacturing device with the above configuration is described. Since the liquid photosensitive adhesive used in the present embodiment has an application thickness of as thin as 0.1 mm or less, viscosity is not particularly limited, and a known liquid photosensitive adhesive can be used. The liquid photosensitive adhesive used in the present embodiment is a UV curable adhesive, "Acrytack T series" (trademark) manufactured by NO-TAPE INDUSTRIAL CO., LTD.

The liquid photosensitive cushion resin 20 used in the present embodiment is thickly applied with an application thickness of from 0.1 to 5 mm and moreover is mixed with air bubbles, and the liquid photosensitive cushion resin having a viscosity of 0.1 Pa·s or more and 10 kPa·s or less (20°C), preferably 1 Pa·s or more and 10 kPa·s or less, or more preferably 10 Pa·s or more and 10 kPa·s or less is preferably used as a binder. By mixing the air bubbles in the liquid photosensitive resin, a liquid photosensitive cushion resin can be obtained. A method of mixing the air bubbles is preferably a method of adding a known already-expanded microcapsule. The already-expanded microcapsule is preferably an already-expanded body of a thermally expanding microcapsule containing a gas such as air, oxygen, nitrogen, helium and the like with a thermoplastic polymer as a shell.

The liquid photosensitive resin used in the present embodiment is composed of prepolymer: 67 parts by weight, monomer: 33 parts by weight, additive: 2.2 parts by weight, photopolymerization initiator: from 1 to 2 parts by weight and its viscosity is 80 Pa·s (20°C). 16 parts by weight of the already-expanded microcapsule was added to the liquid photosensitive resin and uniformly distributed using a commercial small-sized mixer so as to prepare the liquid photosensitive cushion resin 20 with air bubbles. The contents of the prepolymer and the like used in the above are as follows:
Prepolymer: polycarbonate polyurethane terminal methacrylate
Monomer: phenoxy ethyl acrylate
Additive: 2, 6-di-t-butyl-4-methylphenol
Photopolymerization initiator: 2, 2-dimethoxy-1, 2-diphenylethane-1-on
Already-expanded microcapsule: "Matsumoto Microsphere-MFL" (trademark) MFL-100CA manufactured by Matsumoto Yushi-Seiyaku Co., Ltd.

Since the liquid photosensitive laser engraved resin 30 used in the present embodiment is applied thickly with an application thickness of from 0.5 to 5 mm, it is not affected by gravity or centrifugal force by rotation, and since high viscosity is favorable to maintain the application shape, it preferably has viscosity of 6 Pa·s or more and 50 kPa·s or less (20°C), more preferably 100 Pa·s or more and 20 kPa·s or less, or further preferably 200 Pa·s or more and 10 kPa·s or less.

The liquid photosensitive resin used in the present embodiment is composed of prepolymer: 67 parts by weight, monomer: 33 parts by weight, filler: 5.14 parts by weight, additive: 2.8 parts by weight, photopolymerization initiator: from 1 to 2 parts by weight and its viscosity is 340 Pa·s (20°C). The contents of the prepolymer and the like used in the above are as follows:
Prepolymer: polycarbonate polyurethane terminal methacrylate
Monomer: benzyl methacrylate, cyclohexyl methacrylate, butoxy diethylene glycol monomethacrylate
Filler: silicon inorganic filler (spherical, porous)
Additive: 2, 6-di-t-butyl-4-methylphenol
Photopolymerization initiator: benzophenon

The examples of the sleeve 100 for printing may include a sleeve made of FRP (Fiber Reinforced Plastic), CFRP (Carbon Fiber Reinforced Plastic), plastic, nickel plating, iron or metal such as aluminum with a thickness of from 0.1 to several tens mm, and in the present manufacturing device, a sleeve width for printing of 1900 mm and an outer diameter of from 100 to 500 mm can be handled. If the tackiness of the liquid photosensitive adhesive is not reinforced during the light-curing step or the liquid photosensitive adhesive is not used, for example, the outer circumferential surface of the sleeve 100 for printing is preferably applied with surface treatment in advance so as to reinforce the tackiness with the liquid photosensitive cushion resin.

In the following explanation, a manufacturing example using the above-mentioned liquid photosensitive adhesive, the liquid photosensitive cushion resin, and the liquid photosensitive resin is described in detail.

As shown in Figure 4, the spiral coating step of the liquid photosensitive adhesive first starts with advancing the exposure unit 1200 at the standby position to a retreated position at the advance limit by the exposure unit advancing/retreating mechanism (See Figure 3, for example). Then, the dispenser 300 at the standby position is advanced by the dispenser advancing/retreating mechanism to the shaft center of the mandrel 110 and moved to a predetermined thickness control start position by the dispenser transverse mechanism. Subsequently, the dispenser 300 is lowered to a thickness control position at a predetermined height by the dispenser elevation mechanism and the sleeve 100 is rotated to the arrow A direction in Figure 4 at a predetermined speed, while the plunger in the dispenser is pushed down at a predetermined speed so that by supplying a constant amount of the adhesive contained in the cartridge container and by moving the dispenser 300 along the shaft center direction of the sleeve 100 by the dispenser transverse mechanism at a predetermined speed, the spiral coating step of the adhesive is completed. Next, after the dispenser 300 is raised to the height of the standby position by the dispenser elevation mechanism, it is moved to the standby position by the dispenser transverse mechanism and the dispenser advancing/retreating mechanism.

If an adhesive amount contained in the dispenser 300 runs short of a lower limit amount, in addition to control such as an alarm for replacement of a cartridge container and display control, control for temporary interruption is preferably carried out by a plunger-height position detection function.

In the exposure step of the liquid photosensitive adhesive, after the exposure unit 1200 at the retreated position at the advance limit is retreated to the shaft center of the mandrel 110 by the exposure unit advancing/retreating mechanism, it is lowered to an exposure start position at a predetermined height by the exposure unit elevation mechanism according to an outer diameter of the sleeve 100. After that, the ultraviolet-shielding shutter unit is closed, and by lighting the micro-wave non-electrode metal halide lamp 1220 with rotation of the sleeve 100, the ultraviolet exposure step is started. The spiral-coated adhesive layer is light-cured, and the adhesive cured layer 40 is formed. When the exposure step is completed, the ultraviolet-shielding shutter unit is opened, and after the exposure unit 1200 is raised to the height of the retreated position by the exposure unit elevation mechanism, it is advanced to the retreated position by the exposure unit advancing/retreating mechanism.

Also, during the exposure, in order to suppress temperature rise of the sleeve 100, cool air is preferably fed from the sleeve cooling air blower nozzle 1300 to the sleeve 100 as exemplified in Figure 3.

As shown in Figure 4, in the spiral coating step of the liquid photosensitive cushion resin 20, similarly to the spiral coating step of the liquid photosensitive adhesive, the dispenser 400 at the standby position is advanced by the dispenser advancing/retreating mechanism to the shaft center of the mandrel 110 and then, moved to the predetermined thickness control start position by the dispenser transverse mechanism and the ultraviolet-shielding shutter unit is opened. After that, the dispenser 400 is lowered to the thickness control position at the predetermined height by the dispenser elevation mechanism and by pushing down the plunger in the dispenser at a predetermined speed while the sleeve 100 is rotated in the arrow A direction in Figure 4 at a predetermined speed, to quantitatively supply the liquid photosensitive cushion resin 20 contained in the cartridge receptacle, and then, the dispenser 400 is moved along the shaft center direction of the sleeve 100 by the dispenser transverse mechanism at a predetermined speed so that the spiral coating step of the liquid photosensitive cushion resin 20 is completed.

Next, the rotating speed of the sleeve 100 is switched to a high-speed side at which the resin bank 105, which will be described later, can be formed, according to the viscosity of the liquid photosensitive cushion resin 20. At the distal-end taper portion of the doctor blade 800 raised by the doctor elevation mechanism to a predetermined height position (corresponding to the cushion resin thickness) from the standby state, the resin bank 105 in which an extra resin scraped off the liquid photosensitive cushion resin layer 20 on the sleeve 100 is accumulated is formed. The doctor blade 800 is separated from the application layer at a low speed, while the application layer 20 is corrected to a uniform thickness by the resin in the bank 105, and when the doctor blade 800 is lowered to the standby position, the ultraviolet-shielding shutter unit is closed.

After the dispenser 400 is raised to a height of the standby position by the dispenser elevation mechanism, it is moved to the standby position by the dispenser transverse mechanism and the dispenser advancing/retreating mechanism. Moreover, if the liquid photosensitive cushion resin amount contained in the dispenser 400 runs short of a lower limit amount, in addition to control such as an alarm for replacement of a cartridge container and display control, control for temporary interruption is preferably carried out by a plunger-height position detection function.

In the exposure step of the liquid photosensitive cushion resin 20, after the exposure unit 1200 at the retreated position is retreated to the shaft center of the mandrel 110 by the exposure unit advancing/retreating mechanism, it is lowered to the exposure start position at a predetermined height by the exposure unit elevation mechanism according to the outer diameter of the sleeve 100. Then, the ultraviolet-shielding shutter unit is closed, and by lighting the micro-wave non-electrode metal halide lamp 1220 with rotation of the sleeve 100, the ultraviolet exposure step is started. The spiral-coated liquid photosensitive cushion resin layer 20 is light-cured, and the cushion resin cured layer 50 is formed. When the exposure step is completed, the ultraviolet-shielding shutter unit is opened, and after the exposure unit 1200 is raised to the height of the retreated position by the exposure unit elevation mechanism, it is advanced to the retreated position by the exposure unit advancing/retreating mechanism.

Also, during the exposure, in order to suppress temperature rise of the sleeve 100, cool air is preferably fed from the sleeve cooling air blower nozzle 1300 to the sleeve 100. The exposure amount is preferably controlled by an integrated ultraviolet light amount meter, or ultraviolet meter and an exposure time. By irradiating the high-intensity ultraviolet ray preferably having a wavelength region of from 200 to 400 nm and ultraviolet intensity of 10 mW/cm² or more, more preferably of 50 mW/cm² or more, or further preferably of 100 mW/cm² or more, the cushion resin cured layer in which the microcapsules are uniformly distributed within a time during which the microcapsules with a specific gravity lighter than that of the liquid photosensitive cushion resin are not diffused and moved upward can be formed in a short time.

In the resin supply step of the liquid photosensitive laser engraved resin 30, the resin application smoothing unit 600 is in the standby state, and a resin dam function is provided at the resin application smoothing unit 600 in which the coating shutter 630 is raised, and the pair of resin fluidization preventing weirs 610 are moved to predetermined application width positions according to a desired application width. In the resin dam function operated state, the dispenser 500 at the standby position is moved to a predetermined resin supply start position by the dispenser transverse mechanism and the laser engraved resin dispenser elevation mechanism, and then, the dispenser 500 is moved by the dispenser transverse mechanism to a predetermined resin supply stop position at a predetermined speed, while the plunger 540 is pushed in at a predetermined speed according to the application thickness. As a result, the predetermined amount of the liquid resin 30 is supplied to the resin application smoothing unit 600 in the linear mode with a desired application width. Here, the linear mode refers to a state where a given width of the resin is supplied straight in an elongated strip state, and after the resin supply is finished, the dispenser 500 is moved to the standby position by the dispenser transverse mechanism and the laser engraved resin dispenser elevation mechanism. Here, the inclination angle of the resin receiver at the resin application smoothing unit 600 may be set as appropriate in view of a relation with viscosity of the resin in use, but it is preferably from 15 to 60°. Also, the resin supply amount is preferably adjusted as appropriate a pushing-down speed of the plunger 540 in the dispenser according to the application thickness.

Next, the ultraviolet-shielding shutter unit is opened from the closed state and the resin application smoothing unit 600 at the standby position is moved by the resin application smoothing unit advancing/retreating mechanism to the predetermined thickness control start position, and the coating shutter 630 is lowered. After that, the step progresses to steps of application/smoothing/recovery of the liquid resin 30. The rotation driving and rotation control mechanism 210 rotates the sleeve 100 in the arrow A direction in Figure 8 (the rotating speed is different depending on the viscosity, thixotropy, and application thickness of the liquid resin 30 in use), while the resin application smoothing unit 600 is gradually retreated by the resin application smoothing unit advancing/retreating mechanism in the vertical direction of the sleeve 100, and a gap between the outer circumferential surface of the sleeve 100 and the resin application smoothing unit 600 is widened. At a point of time when the applied resin reaches the predetermined application thickness, the resin application smoothing unit 600 is separated from the outer circumferential surface of the sleeve 100 at a stroke while the coating shutter 630 is raised so that the application step is finished in the thickness control. By this control operation, a projecting shape of several millimeters caused by the tackiness of the liquid resin is generated in the liquid resin layer with a uniform thickness applied on the outer circumferential surface of the sleeve 100 (hereinafter referred to as local thickness abnormality), but an extra applied resin of this local thickness abnormality is configured to be scraped off by the doctor blade 800 raised by the doctor elevation mechanism from the standby state to a recovery height position so as to smooth the application layer surface, and the scraped-off recovered resin 80 is contained in a pail 1100 via the doctor recovered resin gutter 810. When the recovery step is completed, the doctor blade 800 is lowered by the doctor elevation mechanism to the standby position, and the ultraviolet-shielding shutter unit is closed.

Also, the recovered resin 70 dropped from the resin application smoothing unit 600 is configured to be contained in the pail 1100 via the recovered resin gutter 820. Since the recovered resins 70 and 80 contained in the pail 1100 contain trash and the like, the trash is preferably removed by filtering processing and the recovered resins 70 and 80 are reused.

The gap between the resin application smoothing unit 600 and the sleeve 100 before rotation start of the sleeve 100 is preferably as narrow as possible. That is because the air bubbles involved immediately before the first contact between the liquid resin 30 and the outer circumferential surface of the sleeve 100 (hereinafter referred to as air bubbles at contact start) are fewer and the air bubbles are contained at the lowermost portion of the application resin layer and do not cause a deficit on the surface of the laser engraved resin cured layer 60, which is preferable.

Moreover, in order to suppress the air bubbles generated when a tip end of the liquid resin 30 applied on the outer circumferential surface of the sleeve 100 makes a cycle and touches the resin application smoothing unit 600 again (hereinafter referred to as air bubbles at seam), the rotating speed of the sleeve 100 is preferably slowed than a standard before the re-touching. Moreover, a temperature (viscosity) of the liquid resin 30 to be applied is preferably stabilized by the temperature control mechanism 620 in order to realize favorable application thickness accuracy.

As mentioned above, in the supply and the application/smoothing/recovery steps of the liquid resin 30, in order to prevent mixture of the air bubbles in the liquid resin 30 to be applied, not only stable supply of a constant amount of the liquid resin 30 but also precise calculations of rotation control of the sleeve 100, the shape of a distal end portion of the coating shutter 630, a retreating speed of the resin application smoothing unit advancing/retreating mechanism, a distal-end nozzle shape of the dispenser 500 and a structure of a supply stop valve, a distance between the nozzle distal end and the resin application smoothing unit 600, a moving speed of the dispenser 500 and the like are important.

In the exposure step of the liquid photosensitive laser engraved resin 30, after the exposure unit 1200 at the retreated position is retreated by the exposure unit advancing/retreating mechanism to the shaft center of the mandrel 110, the unit is lowered to the exposure start position at a predetermined height according to the outer diameter of the sleeve 100 by the exposure unit elevation function. Subsequently, the ultraviolet-shielding shutter unit is closed, and by lighting the micro-wave non-electrode metal halide lamp 1220 with rotation of the sleeve 100, the ultraviolet exposure step is started. The doctor-coated resin layer 30 is light-cured, and the laser engraved resin cured layer 60 is formed. When the exposure step is completed, the ultraviolet-shielding shutter unit is opened, the exposure unit 1200 is raised by the exposure unit elevation mechanism to the height of the standby position and then, retreated to the standby position by the exposure unit advancing/retreating mechanism.

Also, during the exposure, in order to suppress temperature rise of the sleeve 100, cool air is preferably fed from the sleeve cooling air blower nozzle 1300 to the sleeve 100. The exposure amount is preferably controlled by an ultraviolet integrated light amount meter or ultraviolet meter and an exposure time. By irradiating the high-intensity ultraviolet ray preferably having a wavelength region of from 200 to 400 nm and ultraviolet intensity of 10 mW/cm² or more, more preferably of 50 mW/cm² or more, or further preferably of 100 mW/cm² or more, the laser engraved resin cured layer 60 whose printability is improved is formed, and the engraved resin cured layer 60 preferably becomes capable of being engraved by an infrared laser of from 0.7 to 15 micrometer. By improving the printability of the engraved resin cured layer 60 by irradiating the high-intensity ultraviolet ray as mentioned above, notch resistance is improved approximately by twice as compared with a low-intensity fluorescent-lamp ultraviolet light source and the layer becomes resistant against chipping, hardness is lowered approximately by 5 degrees by Shore A, and holding of solid ink is improved.

The thickness accuracy of the seamless sleeve printing original plate after the exposure step is finished is favorable, but in order to obtain the thickness accuracy requiring higher class printing quality, post-treatment such as grinding, polishing and the like is preferably carried out.

Next, the steps progresses to the removal step of the sleeve 100.

The removal of the sleeve 100 is an operation opposite to the attachment process, in which the pressure screw 281 shown in Figure 6 is loosened, the mandrel hub 270 is displaced and the rotation connecting pin 260 is pulled out. Next, by retreating the main shaft spindle 210 and the tailstock 220, the right-side journal of the mandrel 110 is released. The mandrel support table is lowered, and the mandrel 110 is sandwiched only by the split-type bearing 240 in the cantilever manner and then, at the removal position where the swivel table 200 is swung by 30°, a compressed air is introduced into the mandrel 110 from the compressed-air injection piping system 290 connected to a rotary joint, the compressed air is blown out of a compressed-air blowout hole on the outer circumferential surface of the mandrel 110 and the sleeve 100 is removed, which completes the step.

In the above example, the application of the adhesive layer and the cushion layer is carried out by the spiral coating method, and the thickness is made uniform by the taper shape portion 801 of the doctor blade 800, while the printing layer is applied by the doctor-blade coating method, and the extra liquid is recovered using the face different from the taper shape portion 801 of the doctor blade 800. As mentioned above, to make thickness of the adhesive layer and/or the cushion layer uniform and to recover the extra application liquid of the printing layer by the same doctor blade is a preferable method from the viewpoint of space saving of the device and the like. On the contrary to the above example, it may be so configured that the adhesive layer and the cushion layer are applied by the doctor-blade coating method, the extra liquid is recovered by the face different from the taper shape portion 801 of the doctor blade 800, the printing layer is applied by the spiral coating method, and the thickness is made uniform by the taper shape portion 801 of the doctor blade 800. However, since the air bubbles might be involved when the photosensitive resin forming the printing layer is spiral-coated, adjustment of the smoothing on the surface needs devising. Thus, the above example in which the spiral coating is used for application of the adhesive layer and/or the cushion layer is more preferable.

The liquid photosensitive cushion resin was composed of prepolymer: 67 parts by weight, monomer: 33 parts by weight, additive: 2.2 parts by weight, photopolymerization initiator: from 1 to 2 parts by weight and its viscosity was 80 Pa·s (20°C). 16 parts by weight of the already-expanded microcapsule was added to the liquid photosensitive resin and uniformly distributed using a commercial small-sized mixer so as to prepare the liquid photosensitive cushion resin 20 with air bubbles. The contents of the prepolymer and the like used in the above were as follows:
Prepolymer: polycarbonate polyurethane terminal methacrylate (manufactured by Asahi Kasei Chemicals Corporation)
Monomer: phenoxy ethyl acrylate (manufactured by Kyoeisha Chemical Co., Ltd.)
Additive: 2, 6-di-t-butyl-4-methylphenol (manufactured by Japan Chemtech Ltd.)
Photopolymerization initiator: 2, 2-dimethoxy-1, 2-diphenylethane-1-on (manufactured by Nihon Ciba-Geigy K.K.)
Already-expanded microcapsule: "Matsumoto Microsphere-MFL" (trademark) MFL-100CA manufactured by Matsumoto Yushi-Seiyaku Co., Ltd.

Using the photosensitive resin, in the manufacturing device shown in Figure 3, a cylindrical printing substrate was manufactured. Specifically, after the sleeve 100 is rotated, as exemplified in Figure 4, the above-mentioned liquid photosensitive cushion resin was used by the spiral coating method, the spiral coating layer made of the liquid photosensitive cushion resin was formed on the sleeve 100. The doctor blade 800 disposed below the sleeve 100 and having the taper shape portion with the angle α exemplified in Figure 1 of 45° was brought into contact with the spiral coating layer so as to make the application thickness of the spiral coating layer uniform. Subsequently, using the exposure unit (manufactured by Fusion), the spiral coating layer was exposed, and the cushion resin cured layer was formed on the sleeve 100. The thickness of the cushion resin cured layer was from 0.5 to 1.0 mm.

The irregularity was not visually observed on the surface of the cylindrical printing substrate in the embodiment 1 manufactured as above.

### Comparative Example 1

In this Comparative Example, the cylindrical printing substrate was manufactured similarly to the embodiment 1 except a direction in which the doctor blade was brought into contact with the sleeve. Specifically, using the manufacturing device described in Figure 1 of Patent Document 9, to the spiral coating layer made of the liquid photosensitive cushion resin, the doctor blade was sequentially brought into contact from the side so as to manufacture the cylindrical printing substrate in the Comparative Example 1.

To the surface of the cylindrical printing substrate in the Comparative Example 1 manufactured as above, the doctor blade was brought into contact from the side and separated, and masses of the cushion resin were occasionally found on the surface of the cushion resin cured layer. On the surface of the cylindrical printing substrate manufactured in the Comparative Example 1, the thickness abnormality in which the cushion resin was raised in a thread state due to transfer of the mass of the cushion resin was observed. As compared with a region where the mass of the cushion resin was not transferred, the surface rise by the transferred cushion resin was 3 mm at the maximum.

From the above result, in the manufacturing method according to the present embodiment, by controlling the thickness of the application layer by bringing the doctor blade into contact from below the sleeve, as compared with contact from the side of the sleeve, there was no transfer of resin masses and a thickness difference in the application layer could be controlled to from 0.2 to 0.3 mm or less, and there was little irregularity on the surface of the application layer. Therefore, with the manufacturing method according to the present embodiment, cost reduction and resource saving of the cylindrical printing substrate can be promoted.

### Industrial Applicability

According to the present invention, availability of simple manufacture of a cylindrical printing substrate with improved printing quality is provided. Specifically, the invention is useful as the manufacturing method and the device for manufacturing the printing substrate used in formation of a relief image for flexographic printing plate, formation of a relief image for dry offset printing such as can printing, formation of a pattern for surface work such as embossing, and formation of a relief image for printing on a tile and the like.

### Brief Description of the Drawings

Figure 1 shows a sectional outline diagram illustrating a relation between a sleeve and a doctor blade in a present embodiment;
Figure 2 shows an outline sectional diagram of a cylindrical printing substrate obtained by the present manufacturing method having a three-layered structure (adhesive layer/cushion layer/laser engraved resin layer);
Figure 3 shows a side schematic diagram for explaining outline configuration in an example of the device for manufacturing the cylindrical printing substrate according to the present embodiment;
Figure 4 is an outline diagram for explaining a spiral coating step in the present manufacturing method;
Figure 5 is a schematic diagram for explaining outline configuration in an example of the device for manufacturing the cylindrical printing substrate according to the present embodiment;
Figure 6 is a partially assembled diagram illustrating outline configuration of a mandrel connecting rotating mechanism in the device for manufacturing the cylindrical printing substrate according to the present embodiment;
Figure 7 is a right-side partial assembly diagram illustrating outline configuration of a mandrel connecting rotating mechanism in the device for manufacturing the cylindrical printing substrate according to the present embodiment; and
Figure 8 is an outline sectional diagram for explaining a recovery mechanism of a liquid photosensitive resin.

### Description of Symbols

Description of symbols used in each drawing is as follows:
12: shaft center of sleeve, 20: liquid photosensitive cushion resin, 30: liquid photosensitive laser engraved resin, 40: adhesive cured layer, 50: cushion resin cured layer, 60: laser engraved resin cured layer, 70: recovered resin A, 80: recovered resin B, 90: ultraviolet ray, 10, 100: sleeve for printing, 110: mandrel, 15, 105: resin bank, 200: swivel table, 210: rotation driving and rotation control mechanism, 220: main shaft spindle, 230: tailstock, 240: split-type bearing, 260: rotation connecting pin, 270: mandrel hub, 280: ETP bush, 281: pressure screw, 290: compressed-air injection piping system, 300: adhesive dispenser, 400: cushion resin dispenser, 500: laser engraved resin dispenser, 540: plunger, 600: resin application smoothing unit, 610: resin fluidization preventing weir, 620: temperature control mechanism, 630: coating shutter, 800: doctor blade, 801: taper shape portion, 810: doctor recovered resin gutter, 820: recovered resin gutter, 1000: drum, 1010: drum press device, 1020: switching electromagnetic valve, 1030: switching electromagnetic valve, 1040: air bleeding valve, 1100: pail, 1200: exposure unit, 1210: lamp irradiator, 1220: micro-wave non-electrode metal halide lamp, 1300: sleeve cooling air blower nozzle

## Claims

1. A method of manufacturing a cylindrical printing substrate containing a photosensitive resin cured layer (40, 50), comprising the steps of:
(i) forming a spiral coating layer by applying a photosensitive resin having a viscosity of 100 Pa.s or more to 10.000 Pa.s or less at 20°C on a cylindrical support body (10, 100) by a spiral coating method;
(ii) forming an application layer made of the spiral coating layer having a uniform surface by bringing a doctor blade having a taper shaved distal end portion (18, 800) into contact with the spiral coating layer and having the spiral coating layer pass through a gap formed by the doctor blade (18, 800) and the cylindrical support body outer circumferential surface and then, separating the doctor blade (18, 800) from the application layer; and
(iii) forming the photosensitive resin cured layer (40, 50) by light-curing the application layer, wherein the doctor blade (18, 800) is brought into contact with the spiral coating layer from immediately below the shaft center of cylindrical support body (10, 100) and then, the doctor blade (18, 800) is separated downward,
wherein the photosensitive resin cured layer (40, 50) of the cylindrical support body (10, 100) is an adhesive layer (40) and/or a cushion layer (50), and
(iv) further comprising a step of providing a printing layer (60), which is a photosensitive resin layer or a photosensitive resin cured layer on which an irregular pattern can be formed on the surface, or which is a photosensitive resin cured layer on which the irregular pattern is formed on the surface, on the photosensitive resin cured layer.

2. The manufacturing method according to claim 1, wherein the doctor blade (18, 800) has a taper shaped distal end portion in contact with the photosensitive resin.

3. The manufacturing method according to claim 2, wherein the taper shape is inclined so that its height on the side closer to a rotating direction of the cylindrical support body (10, 100) is lower than that on the side farther in the rotating direction.

4. The manufacturing method according to any one of claims 1 to 3, wherein an angle between a vertical direction from a shaft center of the cylindrical support body (10, 100) and the inclined surface is from 30 to 75°.

5. The manufacturing method according to any one of claims 1 to 4, wherein the doctor blade (18, 800) is separated at from 0.5 to 5 mm/min.

6. The manufacturing method according to any one of claims 2 to 4, wherein in the step (ii), when the spiral coating layer passes through the gap between the doctor blade (18, 800) and the cylindrical support body outer circumferential surface, a resin bank (15) in which an extra resin scraped off from the spiral coating layer is accumulated is formed in a taper shaped inclination region of the doctor blade (18, 800).

7. The manufacturing method according to claim 1, wherein a method of forming the irregular pattern on the surface is laser engraving.

8. The manufacturing method according to claim 1 or 7, wherein the step of forming the printing layer (60) is conducted by applying a photosensitive resin composition for printing forming the printing layer (60) on the photosensitive resin cured layer, which is the adhesive layer (40) and/or cushion layer (50), and then, an extra application liquid is recovered by bringing the doctor blade (18, 800) into contact with the printing layer (60) .

9. The manufacturing method according to claim 8, wherein the doctor blade (18, 800) used in the step of recovering and the doctor blade (18, 800) used in the step (ii) are the same doctor blade.

10. The manufacturing method according to any one of claims 1 or 7 to 9, wherein the cushion layer (50) comprises a gas contained in a microcapsule.

11. The manufacturing method according to claim 10, wherein the microcapsule is a thermally expanding microcapsule, and
which further comprises a step of thermally expanding the microcapsule in advance; mixing the microcapsule in a liquid photosensitive resin constituting the cushion layer (50) in a predetermined weight ratio, uniformly distributing it; and applying it as the liquid photosensitive cushion resin including air bubbles in the step (i).

12. The manufacturing method according to claim 11, further comprising a step of obtaining a mixture in which a microcapsule thermally expanded in advance is mixed in a liquid photosensitive resin constituting the cushion layer (50) in a predetermined weight ratio and uniformly distributed, and applying the mixture on a cylindrical support body (10, 100) or an adhesive layer (40) provided on the cylindrical support body (10, 100).

13. The manufacturing method according to any one of claims 1 to 12, wherein the cylindrical support body (10, 100) is a sleeve (100) which is attached and integrated on an outer circumferential surface of a mandrel (110) and whose strength is reinforced in order to hold a cylindrical shape.

14. The manufacturing method according to claim 8, further comprising a step of applying the photosensitive resin composition for printing on the adhesive layer (40) or cushion layer (50) by a doctor-blade coating method.

15. A device for manufacturing a cylindrical printing substrate according to claim 1 using a photosensitive resin, comprising:
a cylindrical support body (10, 100) on which the photosensitive resin is applied;
a dispenser (300, 400) that discharges the photosensitive resin to the cylindrical support body;
a doctor blade (18, 800) disposed immediately below the shaft center of the cylindrical support body (10, 100) and having a taper shaped distal end portion, wherein the photosensitive resin is applied on the cylindrical support body (10, 100) from the dispenser (300, 400) while the cylindrical support body (10, 100) is rotated so as to form a spiral coating layer, the doctor blade (18, 800) is brought into contact with the spiral coating layer from immediately below the shaft center of the cylindrical support body (10, 100) so as to form an application layer, and then, the doctor blade (18, 800) is separated downward, and
a laser engraved resin dispenser (500).

16. The manufacturing device according to claim 15, wherein the taper shape is inclined so that the side closer to the rotating direction of the sleeve (100) is inclined and lower than the side farther from the rotating direction.

17. The manufacturing device according to claim 15 or 16, wherein an angle between a vertical direction from a shaft center of the sleeve (100) and the inclined face is from 30 to 75°.

18. The manufacturing device according to any one of claims 15 to 17, further comprising a mixer for uniformly mixing and distributing a microcapsule in which a gas is contained in the photosensitive resin.

19. The manufacturing device according to any one of claims 15 to 18, further comprising an exposure unit (1200) disposed above the cylindrical support body (10, 100) for forming a photosensitive resin cured layer (40, 50) by light-curing the application layer.

## Patentansprüche

1. Verfahren zur Herstellung eines zylindrischen Drucksubstrats, welches eine gehärtete Schicht eines fotoempfindlichen Harzes (40, 50) aufweist, mit den Schritten:
(i) Bilden einer spiralförmigen Beschichtungsschicht durch Aufbringen eines fotoempfindlichen Harzes mit einer Viskosität von 100 Pa.s oder mehr bis 10.000 Pa.s oder weniger bei 20°C auf einen zylindrischen Trägerkörper (10, 100) mittels eines Spiralbeschichtungsverfahrens;
(ii) Bilden einer Applikationsschicht, die aus der spiralförmigen Beschichtungsschicht gebildet ist und eine gleichmäßige Oberfläche aufweist, indem ein Abstreifer bzw. Rakel mit einem Distalendbereich mit sich verjüngender Form (18, 800) in Kontakt mit der spiralförmigen Beschichtungsschicht gebracht wird, und die spiralförmige Beschichtungsschicht durch einen durch den Abstreifer (18, 800) und die äußere Umfangsoberfläche des zylindrischen Trägerkörpers gebildeten Spalt geführt wird, und anschließend Trennen des Abstreifers (18, 800) von der Applikationsschicht;
(iii) Bilden der gehärteten Schicht des fotoempfindlichen Harzes (40, 50) durch Lichthärten der Applikationsschicht, wobei der Rakel (18, 800) von direkt unterhalb der Wellenmitte des zylindrischen Trägerkörpers (10, 100) mit der spiralförmigen Beschichtungsschicht in Kontakt gebracht wird, und anschließend der Abstreifer (18, 800) nach unten hin abgetrennt wird,
wobei die gehärtete Schicht (40, 50) aus fotoempfindlichem Harz des zylindrischen Trägerkörpers (10, 100) eine Haftschicht (40) und/oder eine Dämpfungsschicht (50) ist, und
(iv) weiterhin umfassend einen Schritt des Bereitstellens einer Druckschicht (60), welches eine Schicht eines fotoempfindlichen Harzes oder eine gehärtete Schicht eines fotoempfindlichen Harzes ist, worauf ein unregelmäßiges Muster auf der Oberfläche gebildet werden kann, oder welches eine gehärtete Schicht eines fotoempfindlichen Harzes ist, worauf das unregelmäßige Muster auf der Oberfläche gebildet ist, auf der gehärteten Schicht des fotoempfindlichen Harzes.

2. Herstellungsverfahren nach Anspruch 1, wobei der Abstreifer (18, 800) einen Distalendbereich mit sich verjüngender Form in Kontakt mit dem fotoempfindlichen Harz aufweist.

3. Herstellungsverfahren nach Anspruch 2, wobei die sich verjüngende Form derart geneigt ist, dass deren Höhe auf der Seite, die näher an der Rotationsrichtung des zylindrischen Trägerkörpers (10, 100) ist, niedriger als die auf der Seite ist, die in Rotationsrichtung weiter entfernt ist.

4. Herstellungsverfahren nach einem der Ansprüche 1 bis 3, wobei der Winkel zwischen der vertikalen Richtung von der Wellenmitte des zylindrischen Trägerkörpers (10, 100) und der geneigten Oberfläche von 30 bis 75° ist.

5. Herstellungsverfahren nach einem der Ansprüche 1 bis 4, wobei der Rakel (18, 800) mit von 0,5 bis 5 mm/min abgetrennt wird.

6. Herstellungsverfahren nach einem der Ansprüche 2 bis 4, wobei in dem Schritt (ii), wenn die spiralförmige Beschichtungsschicht durch den Spalt zwischen dem Abstreifer (18, 800) und der äußeren Umfangsoberfläche des zylindrischen Trägerkörpers verläuft, ein Harzwall (15), bei dem überschüssiges, von der spiralförmigen Beschichtungsschicht abgeschabtes Harz angehäuft ist, in dem sich verjüngenden Neigungsbereich des Abstreifers (18, 800) gebildet wird.

7. Herstellungsverfahren nach Anspruch 1, wobei das Verfahren zum Bilden des unregelmäßigen Musters auf der Oberfläche Lasergravieren ist.

8. Herstellungsverfahren nach Anspruch 1 oder 7, wobei der Schritt des Bildens der Druckschicht (60) durchgeführt wird, indem eine fotoempfindliche Harzzusammensetzung zum Drucken appliziert wird, welche die Druckschicht (60) auf der gehärteten Schicht eines fotoempfindlichen Harzes bildet, welches die Haftschicht (40) oder Dämpfungsschicht (50) ist, und anschließend weitere Applikationsflüssigkeit rückgewonnen wird, indem der Abstreifer (18, 800) in Kontakt mit der Druckschicht (60) gebracht wird.

9. Herstellungsverfahren nach Anspruch 8, wobei der Abstreifer (18, 800), welcher in dem Schritt des Rückgewinnens verwendet wird und der in dem Schritt (ii) verwendete Abstreifer (18, 800) der gleich Abstreifer ist.

10. Herstellungsverfahren nach einem der Ansprüche 1 oder 7 bis 9, wobei die Dämpfungsschicht (50) ein in Mikrokapseln enthaltenes Gas aufweist.

11. Herstellungsverfahren nach Anspruch 10, wobei die Mikrokapsel eine sich thermisch ausdehnende Mikrokapsel ist, und
welches weiterhin einen Schritt des thermischen Expandierens der Mikrokapseln im Voraus beinhaltet; Einmischen der Mikrokapseln in ein die Dämpfungsschicht (50) bildendes flüssiges fotoempfindliches Harz in einem vorbestimmten Gewichtsanteil, gleichmäßiges Verteilen dieser; und Applizieren hiervon als das flüssige fotoempfindliche Dämpfungsharz, welches Luftbläschen enthält, in dem Schritt (i).

12. Herstellungsverfahren nach Anspruch 11, weiterhin umfassend einen Schritt des Gewinnens eines Gemischs, in welchem eine zuvor thermisch expandierten Mikrokapsel in ein flüssiges fotoempfindliches Harz, welches die Dämpfungsschicht (50) bildet, in einem vorbestimmten Gewichtsanteil eingemischt wird und gleichförmig verteilt wird, und Applizieren des Gemischs auf einen zylindrischen Trägerkörper (10, 100) oder eine auf dem zylindrischen Trägerkörper (10, 100) vorgesehene Haftschicht (40).

13. Herstellungsverfahren nach einem der Ansprüche 1 bis 12, wobei der zylindrische Trägerkörper (10, 100) eine Hülle (100) ist, welche auf einer äußeren Umfangsoberfläche eines Dorns (110) angebracht und damit integral ausgestaltet ist, wobei dessen Festigkeit verstärkt ist, um die zylindrische Form zu halten.

14. Herstellungsverfahren nach Anspruch 8, weiterhin umfassend einen Schritt des Applizierens der fotoempfindlichen Harzzusammensetzung zum Drucken auf die Haftschicht (40) oder die Dämpfungsschicht (50) mittels eines Rakelbeschichtungsverfahrens.

15. Vorrichtung zur Herstellung eines zylindrischen Drucksubstrats nach Anspruch 1 unter Verwendung eines fotoempfindlichen Harzes, umfassend:
einen zylindrischen Trägerkörper (10, 100), auf welchen das fotoempfindliche Harz aufgebracht ist;
eine Abgabeeinrichtung (300, 400), welche das fotoempfindliche Harz auf den zylindrischen Trägerkörper abgibt;
einen direkt unter der Wellenmitte des zylindrischen Trägerkörpers (10, 100) angeordneten Abstreifer (18, 800) mit einem Distalendbereich mit sich verjüngender Form, wobei das fotoempfindliche Harz von der Abgabeeinrichtung (300, 400) auf den zylindrischen Trägerkörper (10, 100) aufgebracht wird, während der zylindrische Trägerkörper (10, 100) so rotiert wird, dass eine spiralförmige Beschichtungsschicht gebildet wird, wobei der Abstreifer (18, 800) mit der spiralförmigen Beschichtungsschicht von direkt unterhalb der Wellenmitte des zylindrischen Trägerkörpers (10, 100) in Kontakt gebracht wird, so dass eine Applikationsschicht gebildet wird, und anschließend der Abstreifer (18, 800) nach unten hin abgelöst wird, und
eine Abgabeeinrichtung (500) für Lasergravurharz.

16. Herstellungsvorrichtung nach Anspruch 15, wobei die sich verjüngende Form derart geneigt ist, dass die Seite, die näher an der Rotationsrichtung der Hülle (100) ist, geneigt und niedriger als die Seite ist, die von der Rotationsrichtung weiter entfernt ist.

17. Herstellungsvorrichtung nach Anspruch 15 oder 16, wobei der Winkel zwischen der vertikalen Richtung von der Wellenmitte der Hülle (10, 100) und der geneigten Oberfläche von 30 bis 75° ist.

18. Herstellungsvorrichtung nach einem der Ansprüche 15 bis 17, weiterhin umfassend einen Mischer zum gleichförmigen Mischen und Verteilen von Mikrokapseln, worin ein Gas enthalten ist, in das fotoempfindliche Harz.

19. Herstellungsvorrichtung nach einem der Ansprüche 15 bis 18, weiterhin umfassend eine Belichtungseinheit (1200), die sich oberhalb des zylindrischen Trägerkörpers (10, 100) befindet, um eine gehärtete Schicht eines fotoempfindlichen Harzes (40, 50) durch Bestrahlen der Applikationsschicht mit Licht zu bilden.

## Revendications

1. Procédé de fabrication d'un substrat d'impression cylindrique contenant une couche durcie de résine photosensible (40, 50), comprenant les étapes :
(i) de formation d'une couche de revêtement hélicoïdal par application d'une résine photosensible présentant une viscosité de 100 Pa.s ou supérieure à 10 000 Pa.s ou inférieure à 20°C sur un corps de support cylindrique (10, 100) par un procédé de revêtement hélicoïdal ;
(ii) de formation d'une couche d'application constituée de la couche de revêtement hélicoïdal présentant une surface uniforme par mise en contact d'une lame présentant une portion d'extrémité distale arasée en cône (18, 800) avec la couche de revêtement hélicoïdal et présentant le passage de couche de revêtement hélicoïdal à travers un espace formé par la lame (18, 800) et la surface circonférentielle externe de corps de support cylindrique et ensuite, par séparation de la lame (18, 800) de la couche d'application ; et
(iii) de formation de la couche durcie de résine photosensible (40, 50) par durcissement à la lumière de la couche d'application, dans lequel la lame (18, 800) est mise en contact avec la couche de revêtement hélicoïdal immédiatement sous le centre d'arbre du corps de support cylindrique (10, 100) et ensuite, la lame (18, 800) est séparée vers le bas,
dans lequel la couche durcie de résine photosensible (40, 50) du corps de support cylindrique (10, 100) est une couche adhésive (40) et/ou une couche d'amortissement (50), et
(iv) comprenant de plus une étape de fourniture d'une couche d'impression (60), qui est une couche de résine photosensible ou une couche durcie de résine photosensible sur laquelle un motif irrégulier peut être formé sur la surface, ou laquelle est une couche durcie de résine photosensible sur laquelle le motif irrégulier est formé sur la surface, sur la couche durcie de résine photosensible.

2. Procédé de fabrication selon la revendication 1, dans lequel la lame (18, 800) présente une portion d'extrémité distale arasée en cône en contact avec la résine photosensible.

3. Procédé de fabrication selon la revendication 2, dans lequel la forme de cône est inclinée de sorte que sa hauteur sur le côté plus proche d'une direction de rotation du corps de support cylindrique (10, 100) est inférieure à celle sur le côté plus éloigné dans la direction de rotation.

4. Procédé de fabrication selon l'une quelconque des revendications 1 à 3, dans lequel un angle entre une direction verticale à partir d'un centre d'arbre du corps de support cylindrique (10, 100) et la surface inclinée est de 30 à 75°.

5. Procédé de fabrication selon l'une quelconque des revendications 1 à 4, dans laquelle la lame (18, 800) est séparée à de 0,5 à 5 mm/min.

6. Procédé de fabrication selon l'une quelconque des revendications 2 à 4, dans lequel dans l'étape (ii), lorsque la couche de revêtement hélicoïdal passe à travers l'espace entre la lame (18, 800) et la surface circonférentielle externe de corps de support cylindrique, un remblai de résine (15), dans lequel une résine excédante raclée à partir de la couche de revêtement hélicoïdal est accumulée, est formé dans une région d'inclinaison en forme de cône de la lame (18, 800).

7. Procédé de fabrication selon la revendication 1, dans lequel un procédé de formation du motif irrégulier sur la surface est une gravure au laser.

8. Procédé de fabrication selon la revendication 1 ou 7, dans lequel l'étape de formation de la couche d'impression (60) est réalisée en appliquant une composition de résine photosensible pour l'impression formant la couche d'impression (60) sur la couche durcie de résine photosensible, laquelle est la couche adhésive (40) et/ou une couche d'amortissement (50), et ensuite, un liquide d'application excédant est récupéré en mettant la lame (18, 800) en contact avec la couche d'impression (60).

9. Procédé de fabrication selon la revendication 8, dans lequel la lame (18, 800) utilisée dans l'étape de récupération et la lame (18, 800) utilisée dans l'étape (ii) sont la même lame.

10. Procédé de fabrication selon l'une quelconque des revendications 1 ou 7 à 9, dans lequel la couche d'amortissement (50) comprend un gaz contenu dans une microcapsule.

11. Procédé de fabrication selon la revendication 10, dans lequel la microcapsule est une microcapsule thermiquement expansible, et lequel comprend de plus une étape d'expansion thermique de la microcapsule à l'avance ; de mélange de la microcapsule dans une résine photosensible liquide constituant la couche d'amortissement (50) dans un rapport massique prédéterminé, la distribuant uniformément ; et l'application de celle-ci comme la résine d'amortissement photosensible liquide comprenant des bulles d'air dans l'étape (i).

12. Procédé de fabrication selon la revendication 11, comprenant de plus une étape d'obtention d'un mélange dans lequel une microcapsule thermiquement expansée à l'avance est mélangée dans une résine photosensible liquide constituant la couche d'amortissement (50) dans un rapport massique prédéterminé et est uniformément distribuée, et l'application du mélange sur un corps de support cylindrique (10, 100) ou une couche adhésive (40) fournie sur le corps de support cylindrique (10, 100).

13. Procédé de fabrication selon l'une quelconque des revendications 1 à 12, dans lequel le corps de support cylindrique (10, 100) est un manchon (100) qui est fixé et intégré sur une surface circonférentielle externe d'un mandrin (110) et dont la résistance est renforcée afin de maintenir une forme cylindrique.

14. Procédé de fabrication selon la revendication 8, comprenant de plus une étape d'application de la composition de résine photosensible pour l'impression sur la couche adhésive (40) ou la couche d'amortissement (50) par un procédé de revêtement à la lame.

15. Dispositif de fabrication d'un substrat d'impression cylindrique selon la revendication 1 utilisant une résine photosensible, comprenant :
un corps de support cylindrique (10, 100) sur lequel la résine photosensible est appliquée ;
un distributeur (300, 400) qui décharge la résine photosensible sur le corps de support cylindrique ;
une lame (18, 800) disposée immédiatement sous le centre d'arbre du corps de support cylindrique (10, 100) et présentant une portion d'extrémité distale en forme de cône, dans lequel la résine photosensible est appliquée sur le corps de support cylindrique (10, 100) à partir du distributeur (300, 400) alors que le corps de support cylindrique (10, 100) tourne afin de former une couche de revêtement hélicoïdal, la lame (18, 800) est mise en contact avec la couche de revêtement hélicoïdal immédiatement sous le centre d'arbre du corps de support cylindrique (10, 100) afin de former une couche d'application, et la lame (18, 800) est ensuite séparée vers le bas, et
un distributeur de résine gravée au laser (500).

16. Dispositif de fabrication selon la revendication 15, dans lequel la forme de cône est inclinée de sorte que le côté le plus proche de la direction de rotation du manchon (100) est incliné et inférieur au côté plus éloigné de la direction de rotation.

17. Dispositif de fabrication selon la revendication 15 ou 16, dans lequel un angle entre une direction verticale à partir d'un centre d'arbre du manchon (100) et la face inclinée est de 30 à 75°.

18. Dispositif de fabrication selon l'une quelconque des revendications 15 à 17, comprenant de plus un mélangeur pour mélanger et distribuer uniformément une microcapsule dans laquelle un gaz est contenu dans la résine photosensible.

19. Dispositif de fabrication selon l'une quelconque des revendications 15 à 18, comprenant de plus une unité d'exposition (1200) disposée sur le corps du support cylindrique (10, 100) pour former une couche durcie de résine photosensible (40, 50) par durcissement à la lumière de la couche d'application.
